# EUROPEAN PATENT APPLICATION

(11) **EP 4 685 499 A1**
(43) Date of publication of application: **28.01.2026**
(21) Application number: 24777822.8
(22) Date of filing: 20.03.2024
(51) Int. Cl.: G01R 31/28, B41J 2/175, G01R 31/52

(54) **CHIP SHORT-CIRCUIT CHECK METHOD AND APPARATUS, CHIP TESTING METHOD, AND CHIP AND CONSUMABLE BOX**

(30) Priority: 26.03.2023 CN 202310301995; 24.07.2023 CN 202321960927 U; 15.12.2023 CN 202311737080
(71) Applicant: Hangzhou Chipjet Technology Co., Ltd., Binjiang District Hangzhou Zhejiang 310052 (CN)
(72) Inventor: ZHANG, Shouyu, Hangzhou, Zhejiang 310052 (CN); LIU, Tianxiang, Hangzhou, Zhejiang 310052 (CN); HONG, Ke, Hangzhou, Zhejiang 310052 (CN); LU, Junjie, Hangzhou, Zhejiang 310052 (CN)
(74) Representative: Meyer-Dulheuer MD Legal Patentanwälte PartG mbB
(86) International application number: PCT/CN2024/082688
(87) International publication number: WO 2024/199033

(57) **Abstract**

A chip short-circuit check method and apparatus, a chip testing method, and a chip and a consumable box are provided. The chip includes a substrate, a grounding terminal, at least two conductive terminals, and a testing portion. The substrate has a first half region and a second half region. The grounding terminal includes a ground wire contact portion configured to be in contact with a stylus of a printer, and located in the first half region. The at least two conductive terminals are located in the second half region and arranged spaced apart from each other. Each conductive terminal includes a contact portion configured to be in contact with the stylus of the printer. The testing portion is located on the substrate and electrically connected to the grounding terminal. The testing portion includes a first testing line segment located between a first conductive terminal and a second conductive terminal.

## Description

### CROSS-REFERENCE TO RELATED APPLICATIONS

This application claims priority to Chinese patent application No. 202310301995.4, filed on March 26, 2023, and titled "CHIP SHORT-CIRCUIT CHECK METHOD AND APPARATUS, CHIP AND INK CARTRIDGE", Chinese patent application No. 202321960927.0, filed on July 24, 2023, and titled "CHIP AND INK CARTRIDGE", and Chinese patent application No. 202311737080.4, filed on December 15, 2023 and titled "CHIP SHORT-CIRCUIT CHECK METHOD AND APPARATUS, CHIP TESTING METHOD, AND CHIP AND CONSUMABLE BOX". The contents of the above identified applications are hereby incorporated herein in their entireties by reference.

### TECHNICAL FIELD

The present invention relates to the field of printing device technology, and in particular, to a chip short-circuit check method and apparatus, a chip testing method, and a chip and a consumable box.

### BACKGROUND

A common printing device is equipped with a detachable consumable box to facilitate replacement of a new consumable box after ink is exhausted. An ink cartridge, a toner cartridge, an ink bag box and the like are common consumable boxes, each of which is usually equipped with a chip, and the chip can store various information and communicate with the printing device.

The chip is usually provided with a power terminal (VDD), a data terminal (DATA), a clock terminal (CLK), a reset terminal (RST/CE), a grounding terminal (GND) and the like. Since ink in the consumable box may be dripped to the terminal of the chip or other conductive materials are attached to the terminal, if adjacent terminals are connected through the ink or the conductive materials, the chip or even the printing device may have a short-circuit fault or even be burnt out. Therefore, short-circuit check is usually performed on the chip, and after the chip passes the short-circuit check, the printing device transmits a subsequent normal communication command to the chip.

At present, in a short-circuit check phase of the chip, the printing device may first transmit a short-circuit check command to the chip, and then the data terminal in the chip returns a waveform that conforms to an expectation of the printing device, indicating that the chip is not short-circuited, otherwise it is considered that the chip is short-circuited. However, in an actual application process, when a function of the chip is damaged, the chip cannot return a waveform that conforms to the expectation of the printing device in the short-circuit check phase of the chip, resulting in an error in determining a short-circuit check result of the chip.

For the issue of the error in determining the short-circuit check result of the chip in the related art, no effective solution has been proposed at present.

### SUMMARY

According to various embodiments of the present invention, a chip short-circuit check method and apparatus, a chip testing method, and a chip and a consumable box are provided.

In a first aspect, the present invention provides a chip adapted to be communicatively connected to a printer. The chip includes a substrate, a grounding terminal, at least two conductive terminals, and a testing portion. The substrate has a first half region and a second half region. The grounding terminal includes a ground wire contact portion configured to be in contact with a stylus of the printer, and the ground wire contact portion is located in the first half region of the substrate. The at least two conductive terminals are located in the second half region of the substrate and arranged spaced apart from each other. Each of the at least two conductive terminals includes a contact portion configured to be in contact with a stylus of the printer. The at least two conductive terminals include a first conductive terminal and a second conductive terminal. A distance between the contact portion of the first conductive terminal and the contact portion of the second conductive terminal is less than that between the ground wire contact portion and either of the contact portion of the first conductive terminal and the contact portion of the second conductive terminal. The testing portion is located on the substrate and electrically connected to the grounding terminal. The testing portion includes a first testing line segment located between the first conductive terminal and the second conductive terminal. The first testing line segment is arranged spaced apart from each of the first conductive terminal and the second conductive terminal.

In some embodiments, the testing portion further includes a second testing line segment. The second testing line segment and the first testing line segment are located at two adjacent sides of the first conductive terminal, and the second testing line segment cooperates with the first testing line segment to surround the first conductive terminal.

In some embodiments, the testing portion surrounds the first conductive terminal with a notch.

In some embodiments, an intersecting point of the second testing line segment and the first testing line segment is proximal to the contact portion of the first conductive terminal and away from the ground wire contact portion.

In some embodiments, the at least two conductive terminals further include a third conductive terminal. The third conductive terminal is spaced apart from the first conductive terminal, and the second testing line segment is located between the first conductive terminal and the third conductive terminal. The first conductive terminal is covered by a projection of the second testing line segment along an arraying direction of the third conductive terminal and the first conductive terminal.

In some embodiments, the quantity of the conductive terminals is four, and the quantity of the grounding terminal is one. The chip further includes a detecting terminal. When the chip is in the mounted state, the detecting terminal is electrically isolated from the stylus of the printer.

In some embodiments, the at least two conductive terminals further include a third conductive terminal and a fourth conductive terminal. A distance between the contact portion of the third conductive terminal and the contact portion of the fourth conductive terminal is less than that between the ground wire contact portion and either of the contact portion of the third conductive terminal and the contact portion of the fourth conductive terminal. The first conductive terminal and the second conductive terminal are arranged along a first direction, and the fourth conductive terminal and the second conductive terminal are sequentially arranged along a second direction intersecting with the first direction. The grounding terminal, the third conductive terminal, and the first conductive terminal are sequentially arranged along the second direction. The contact portion of the first conductive terminal and the ground wire contact portion are symmetric with respect to a boundary dividing the first half region and the second half region.

In some embodiments, the testing portion further includes either or both of a third testing line segment and a fourth testing line segment. The third testing line segment, the first testing line segment, and the second testing line segment cooperate with each other to surround the third conductive terminal. The fourth testing line segment is located between the second conductive terminal and the fourth conductive terminal. The second conductive terminal is covered by a projection of the fourth testing line segment along an arraying direction of the fourth conductive terminal and the second conductive terminal.

In some embodiments, the chip further includes a memory and a processor. The memory is electrically connected to the processor. The processor is electrically connected to the first conductive terminal, and the processor is configured to process a signal of the first conductive terminal. Exemplarily, the memory is electrically connected to the first conductive terminal. Exemplarily, the processor is electrically connected to the second conductive terminal. Exemplarily, the memory is electrically connected to the second conductive terminal.

In some embodiments, the at least two conductive terminals further include a third conductive terminal and a fourth conductive terminal. The contact portion of the first conductive terminal and the ground wire contact portion are asymmetric with respect to a boundary dividing the first half region and the second half region. A connecting direction of the contact portion of the third conductive terminal and the ground wire contact portion is intersected with that of the contact portion of the second conductive terminal and the contact portion of the fourth conductive terminal.

In some embodiments, the first conductive terminal may be a clock terminal, the second conductive terminal may be a data terminal, the third conductive terminal may be a power terminal, and the fourth conductive terminal may be a reset terminal.

Exemplarily, the chip further includes a circuit pattern. The processor is electrically connected to the first conductive terminal and the second conductive terminal through the circuit pattern, and may be electrically connected to the memory through the circuit pattern. The processor may be configured to process a signal of the second conductive terminal.

In the chip provided by the present invention, abnormality recognition between the conductive terminals and the circuit pattern can be taken into account by providing the testing portion.

In a second aspect, the present invention further provides a consumable box. The consumable box includes the chip mentioned above.

In some embodiments, the consumable box includes a box body. The box body has a bottom wall and a side wall. The chip is mounted on the side wall of the box body, and a boundary of the chip configured for dividing the first half region and the second half region is perpendicular to the bottom wall.

In some embodiments, the grounding terminal and the second conductive terminal are disposed oppositely and separated by the first testing line segment. The grounding terminal is located at a side of the first testing line segment proximal to the bottom wall. The second conductive terminal is located at a side of the first testing line segment away from the bottom wall. An extending direction of the first testing line segment is parallel to the bottom wall.

In a third aspect, the present invention further provides a printing system. The printing system includes a printer and the consumable box mentioned above. The consumable box is detachably connected to the printer, and a chip of the consumable box is electrically connected to the printer.

In a fourth aspect, the present invention provides a chip testing method, applied to a to-be-tested chip provided with a testing portion. The to-be-tested chip further includes a substrate, a grounding terminal, a clock terminal, a data terminal, a power terminal, and a reset terminal. The testing portion is located on the substrate and electrically connected to the grounding terminal. The testing portion includes a first testing line segment, a second testing line segment, and a grounding line segment. The first testing line segment is connected to the grounding terminal through the grounding line segment. The data terminal and the reset terminal are located at a side of the first testing line segment. The clock terminal and the power terminal are located at another side of the first testing line segment. The second testing line segment is connected to the first testing line segment, and the clock terminal and the power terminal are separated by the second testing line segment. The method includes: acquiring a short-circuit check signal, setting desired level signals for the data terminal in the to-be-tested chip at specified time points in a check response period based on the short-circuit check signal, acquiring actual output level signals of the data terminal after the desired level signals are set for the data terminal, and determining a test result of the to-be-tested chip based on the actual output level signals. The test result of the to-be-tested chip indicates that the to-be-tested chip functions normally or the to-be-tested chip has faults.

In some embodiments, determining the test result of the to-be-tested chip based on the actual output level signals further includes: when the actual output level signals are consistent with the desired level signals, determining that the test result of the to-be-tested chip indicates that the to-be-tested chip functions normally; and when the actual output level signals are inconsistent with the desired level signals, determining that the test result of the to-be-tested chip indicates that the to-be-tested chip has the faults. The faults of the to-be-tested chip include at least one of a short circuit between remaining terminals of the to-be-tested chip other than the reset terminal, either or both of a short circuit between the reset terminal and the clock terminal and a short circuit between the reset terminal and the power terminal, a short circuit between any terminal other than the reset terminal and the testing portion, or a functional damage of the to-be-tested chip.

In some embodiments, when the actual output level signals are consistent with the desired level signals, the method further includes: determining whether a voltage of the reset terminal of the to-be-tested chip is continuously within a preset voltage range in the check response period; when the voltage of the reset terminal of the to-be-tested chip is continuously within the preset voltage range in the check response period, determining that no short circuit exists in the to-be-tested chip; and when the voltage of the reset terminal of the to-be-tested chip is not continuously within the preset voltage range in the check response period, determining that a short circuit between the reset terminal and the data terminal or a short circuit between the reset terminal and the grounding terminal exists in the to-be-tested chip.

In a fifth aspect, the present invention provides a chip short-circuit check method, including: acquiring a short-circuit check signal, setting desired level signals for a data terminal in a to-be-tested chip at specified time points in a check response period based on the short-circuit check signal, acquiring actual output level signals of the data terminal after the desired level signals are set for the data terminal, and determining a short-circuit check result of the to-be-tested chip based on the actual output level signals. The short-circuit check result indicates that the to-be-tested chip functions normally although a short circuit between a reset terminal and at least one terminal other than the reset terminal exists in the to-be-tested chip, the to-be-tested chip functions normally and is free of short circuits, or the to-be-tested chip is functionally damaged.

In some embodiments, determining the short-circuit check result of the to-be-tested chip based on the actual output level signals further includes: when the actual output level signals are inconsistent with the desired level signals, determining that the short-circuit check result indicates that the to-be-tested chip is functionally damaged.

In some embodiments, when the actual output level signals are consistent with the desired level signals, it is determined that the to-be-tested chip functions normally, and the method further includes: determining whether a voltage of the reset terminal of the to-be-tested chip is continuously within a preset voltage range in the check response period; when the voltage of the reset terminal of the to-be-tested chip is continuously within the preset voltage range in the check response period, determining that no short circuit exists in the to-be-tested chip; and when the voltage of the reset terminal of the to-be-tested chip is not continuously within the preset voltage range in the check response period, determining that a short circuit between the reset terminal and at least one terminal other than the reset terminal exists in the to-be-tested chip.

In some embodiments, when the actual output level signals are consistent with the desired level signals, it is determined that the to-be-tested chip functions normally, and the method further includes: determining whether the to-be-tested chip responds to a communicating command in a preset communicating period; when the to-be-tested chip does not respond to the communicating command in the preset communicating period, determining that the short-circuit check result indicates that the to-be-tested chip functions normally although a short circuit between the reset terminal and at least one terminal other than the reset terminal exists in the to-be-tested chip; and when the to-be-tested chip responds to the communicating command in the preset communicating period, determining that the short-circuit check result indicates that the to-be-tested chip functions normally and is free of short circuits. The communicating command is transmitted by a printing device communicating with the to-be-tested chip, and the preset communicating period is after the check response period.

In some embodiments, setting the desired level signals for the data terminal in the to-be-tested chip at the specified time points in the check response period based on the short-circuit check signal further includes: determining a plurality of clock time points of a clock terminal in the to-be-tested chip based on the short-circuit check signal, determining the check response period based on the plurality of clock time points, determining the specified time points corresponding to the data terminal in the to-be-tested chip in the check response period, and setting the desired level signals at the specified time points corresponding to the data terminal.

In some embodiments, the specified time points include a first specified time point, a second specified time point, and a third specified time point. The first specified time point is earlier than the second specified time point. The second specified time point is earlier than the third specified time point. Setting the desired level signals at the specified time points corresponding to the data terminal further includes: setting a low-level signal at the first specified time point corresponding to the data terminal, setting a high-level signal at the second specified time point corresponding to the data terminal, and setting a low-level signal at the third specified time point corresponding to the data terminal.

In some embodiments, acquiring the short-circuit check signal further includes: acquiring original waveform data transmitted by a printing device; and determining the original waveform data as the short-circuit check signal when the original waveform data has a short-circuit check identifier.

In a sixth aspect, the present invention provides a chip short-circuit check apparatus, including a first acquiring module, a level signal setting module, a second acquiring module, and a determining module. The first acquiring module is configured for acquiring a short-circuit check signal. The level signal setting module is configured for setting desired level signals for a data terminal in a to-be-tested chip at specified time points in a check response period based on the short-circuit check signal. The second acquiring module is configured for acquiring actual output level signals of the data terminal after the desired level signals are set for the data terminal. The determining module is configured for determining a short-circuit check result of the to-be-tested chip based on the actual output level signals. The short-circuit check result indicates that the to-be-tested chip functions normally although a short circuit between a reset terminal and at least one terminal other than the reset terminal exists in the to-be-tested chip, the to-be-tested chip functions normally and is free of short circuits, or the to-be-tested chip is functionally damaged.

In a seventh aspect, the present invention provides a chip. The chip includes a clock terminal, a data terminal, a power terminal, a grounding terminal, a reset terminal, and a processor. The processor is configured to perform the chip testing method in any embodiment of the fourth aspect, or perform the chip short-circuit check method in any embodiment of the fifth aspect.

In an eighth aspect, the present invention provides a consumable box. The consumable box includes the chip in the seventh aspect.

Details of one or more embodiments of the present invention are presented in the attached drawings and descriptions below. And other features, purposes and advantages of the present invention will become apparent from the description, drawings and claims.

### BRIEF DESCRIPTION OF THE DRAWINGS

In order to more clearly illustrate the technical solutions in the embodiments of the present invention or the related art, the accompanying drawings that need to be used in the description of the embodiments or the related art will be briefly introduced below. It is obvious that the accompanying drawings in the following description are the embodiments of the present invention, and one skilled in the art can obtain other drawings according to the disclosed drawings without creative efforts.
FIG. 1 is a schematic structural view of a chip according to the present invention.
FIG. 2 is a schematic structural view of a chip according to the present invention.
FIG. 3 is a schematic structural view of a chip according to the present invention.
FIG. 4 is a schematic structural view of a chip according to the present invention.
FIG. 5 is a schematic structural view of a chip according to the present invention.
FIG. 6 is a schematic block diagram of a printing system according to the present invention.
FIG. 7 is a waveform diagram of the chip when operating normally according to the present invention.
FIG. 8 is a waveform diagram when a reset terminal and a clock terminal in the chip are short-circuited according to the present invention.
FIG. 9 is a waveform diagram when the reset terminal and a data terminal in the chip are short-circuited according to the present invention.
FIG. 10 is a waveform diagram when the reset terminal and a power terminal in the chip are short-circuited according to the present invention.
FIG. 11 is a waveform diagram when the clock terminal and the power terminal in the chip are short-circuited according to the present invention.
FIG. 12 is a waveform diagram when the clock terminal and the data terminal in the chip are short-circuited according to the present invention.
FIG. 13 is a waveform diagram when the power terminal and the data terminal in the chip are short-circuited according to the present invention.
FIG. 14 is a schematic exploded view of a consumable box according to the present invention.
FIG. 15 is a partial enlarged view of FIG. 14.
FIG. 16 is a schematic front view of the consumable box according to the present invention.
FIG. 17 is a schematic structural view of a chip according to the present invention.
FIG. 18 is a schematic structural view of a chip according to the present invention.
FIG. 19 is a schematic diagram of an application scenario of a chip short-circuit check method according to the present invention.
FIG. 20 is a flowchart of the chip short-circuit check method according to the present invention.
FIG. 21 is a schematic structural view of a to-be-tested chip according to the present invention.
FIG. 22 is a complete waveform diagram of short-circuit check of a chip when the chip functions normally and no short circuit exists according to the present invention.
FIG. 23 is a schematic diagram of a waveform in a check response period provided by a printing device in the related art.
FIG. 24 is a schematic diagram of an original waveform of a short-circuit check signal transmitted by a printing device in the related art.
FIG. 25 is a schematic diagram of an original waveform of each terminal according to the present invention.
FIG. 26 is a schematic waveform diagram when the reset terminal and the clock terminal are short-circuited according to the present invention.
FIG. 27 is a schematic waveform diagram when the reset terminal and the data terminal corresponding to a first data signal SDA1 are short-circuited according to the present invention.
FIG. 28 is a schematic waveform diagram when the reset terminal and the data terminal corresponding to a second data signal SDA2 are short-circuited according to the present invention.
FIG. 29 is a schematic waveform diagram when the reset terminal and the data terminal corresponding to a third data signal SDA3 are short-circuited according to the present invention.
FIG. 30 is a schematic waveform diagram when the reset terminal and the data terminal corresponding to a fourth data signal SDA4 are short-circuited according to the present invention.
FIG. 31 is a schematic waveform diagram when the reset terminal and the power terminal are short-circuited according to the present invention.
FIG. 32 is a schematic waveform diagram when the reset terminal and the grounding terminal are short-circuited according to the present invention.
FIG. 33 is a schematic structural view of a to-be-tested chip provided with a testing portion according to the present invention.
FIG. 34 is a flowchart of a chip testing method according to the present invention.
FIG. 35 is a schematic waveform diagram when the clock terminal and the power terminal are short-circuited according to the present invention.
FIG. 36 is a schematic waveform diagram when the clock terminal and the data terminal are short-circuited according to the present invention.
FIG. 37 is a schematic waveform diagram when the power terminal and the data terminal are short-circuited according to the present invention.
FIG. 38 is another schematic waveform diagram when the reset terminal and the clock terminal are short-circuited according to the present invention.
FIG. 39 is another schematic waveform diagram when the reset terminal and the power terminal are short-circuited according to the present invention.
FIG. 40 is a structural block diagram of a chip short-circuit check apparatus according to the present invention.
FIG. 41 is a schematic diagram of an internal structure of a computer device according to the present disclosure.

LIST OF REFERENCE NUMERALS: 1 represents a first conductive terminal, 11 represents a first contact portion, 2 represents a second conductive terminal, 21 represents a second contact portion, 3 represents a third conductive terminal, 31 represents a third contact portion, 4 represents a fourth conductive terminal, 41 represents a fourth contact portion, 5 represents a grounding terminal, 51 represents a ground wire contact portion, 6 represents a testing portion, 60 represents a grounding line segment, 61 represents a first testing line segment, 62 represents a second testing line segment, 63 represents a third testing line segment, 64 represents a fourth testing line segment, 65 represents a fifth testing line segment, 10 represents a substrate, 20 represents a first processor, 30 represents a memory, 100 represents a chip, 200 represents a printer, 201 represents a second processor, 300 represents a consumable box, 310 represents a box body, 301 represents a bottom wall, 302 represents a first side wall, 303 represents an ink outlet, 102 represents a terminal device, 104 represents a server, 401 represents a data terminal, 402 represents a reset terminal, 403 represents a clock terminal, 404 represents a power terminal, 221 represents a first acquiring module, 222 represents a level signal setting module, 223 represents a second acquiring module, and 224 represents a determining module.

### DETAILED DESCRIPTION

The technical solutions in the embodiments of the present invention will be described clearly and completely with reference to the accompanying drawings in the embodiments of the present invention. Apparently, the embodiments as described are merely some rather than all of the embodiments of the present invention. All other embodiments obtained by one skilled in the art on the basis of the embodiments in the present invention without involving any inventive effort fall within the protection scope of the present invention.

In the description of the present invention, it should be understood that orientations or positional relationships indicated by terms such as "center", "longitudinal", "lateral", "length", "width", "thickness", "upper", "lower", "front", "rear", "left", "right", "vertical", "perpendicular", "horizontal", "top", "bottom", "inner", "outer", "clockwise", "counterclockwise", "axial", "radial", and "circumferential" are based on the orientations or positional relationships shown in the drawings, which are merely for the convenience of describing the present invention and simplifying the description, and do not indicate or imply that the referred apparatus or element must have a specific orientation, be constructed and operated in a specific orientation, and therefore cannot be understood as a limitation on the present invention.

In the present invention, unless otherwise explicitly specified and defined, a first feature being "on" or "under" a second feature may refer to the first feature and the second feature being in direct contact, or in indirect contact through an intermediary. Also, when the first feature is described as "on", "above", and "over" the second feature, this may mean the first feature is directly above or obliquely above the second feature, or merely indicate that the first feature is horizontally higher than the second feature. When the first feature is described as "under", "below", and "beneath" the second feature, this may mean the first feature is directly below or obliquely below the second feature, or merely indicate that the first feature is horizontally lower than the second feature.

In addition, terms such as "first", "second", and "third" are merely used for descriptive purposes, and cannot be understood as indicating or implying relative importance or implicitly indicating the quantity of the technical features referred to. Thus, a feature defined with "first" and "second" may explicitly or implicitly include at least one of features. Exemplarily, among a plurality of conductive terminals, a first conductive terminal may be referred to as a third conductive terminal, a third conductive terminal may also be referred to as a first conductive terminal, and a fourth conductive terminal may be referred to as a second conductive terminal, a second conductive terminal may also be referred to as a fourth conductive terminal. In the description of the present invention, "a plurality of" means at least two, for example, two, three, and the like, unless specifically defined otherwise.

In the present invention, unless otherwise specified and defined, terms such as "connected", and "coupling" should be understood broadly, for example, may be a fixed connection, a detachable connection, or an integral connection; a flexible connection, or a rigid connection along at least one direction; a mechanical connection, or an electrical connection; a direct connection, an indirect connection through an intermediate medium, or a direct connection with an intermediate medium; or an internal communication between two elements or an interaction relationship between two elements, unless otherwise specified. Terms such as "mounted", "disposed", and "fixed" may be understood broadly as connected. For one skilled in the art, specific meanings of the foregoing terms in the present invention may be understood according to specific situations.

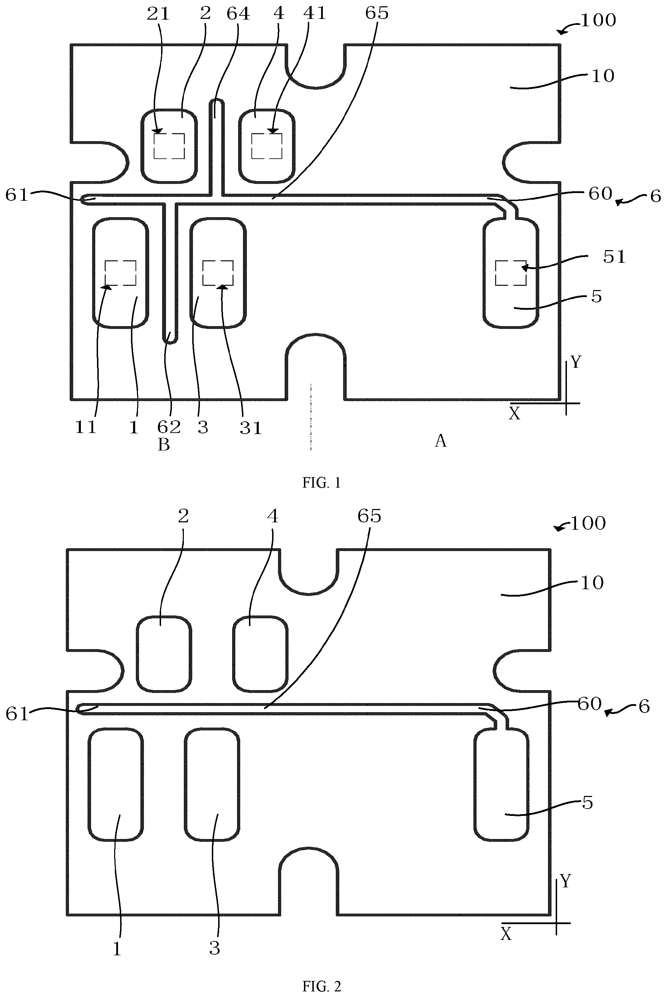

FIG. 1 is a chip in the present invention. In some embodiments, the chip 100 according to the present invention may include a substrate 10, a grounding terminal 5, a testing portion 6, and at least two conductive terminals.

The substrate 10 may include a printed circuit board, which may have a single-layer structure or multi-layer structure. The surface shown in FIG. 1 may be an operating surface of the substrate 10. Exemplarily, the chip 100 may further include a circuit pattern (not shown) disposed on the substrate 10, and the circuit pattern may be located on the operating surface of the substrate 10, or may be located in other layers. The circuit pattern may be electrically connected to respective conductive terminals. The substrate 10 may have a generally rectangular outer contour in an XY plane, and the rectangular outer contour may be considered to have a central axis. The substrate 10 may be divided into a first half region A and a second half region B, and a boundary between the first half region A and the second half region B may be substantially perpendicular to an X-axis direction. For example, in FIG. 1, a right half of the substrate 10 may be the first half region A, and a left half of the substrate 10 may be the second half region B.

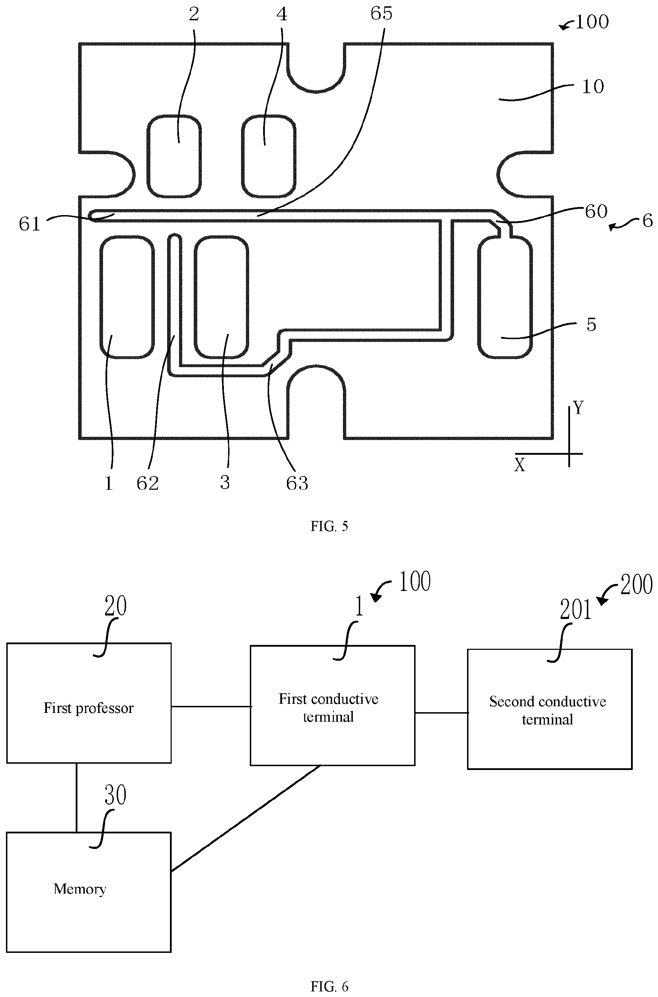

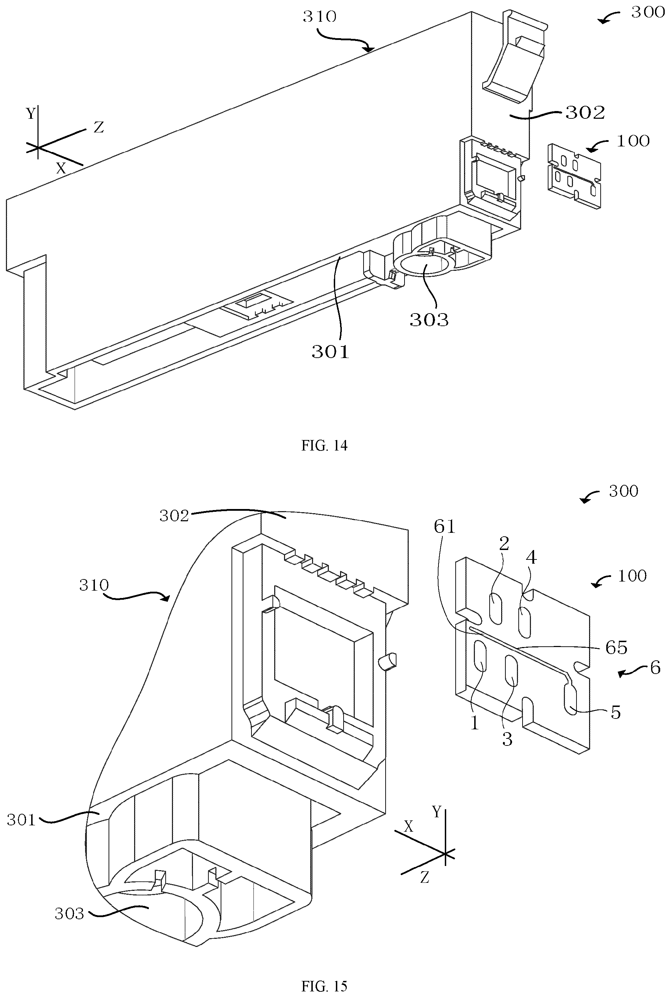

All the grounding terminal 5 and the at least two conductive terminals may be located on the operating surface of the substrate 10. The chip 100 may be electrically connected to a printer 200 (FIG. 6) through the grounding terminal 5 and these conductive terminals. For example, the chip 100 may be disposed in a box body 310 of a consumable box 300 (FIG. 14), and then may be mounted to the printer 200 together. The printer 200 may check whether the chip 100 is mounted in place, and a checking method is usually to detect signals of respective terminals, so as to determine whether the terminals are in good contact with styluses.

Referring to FIG. 1, the grounding terminal 5 may include a ground wire contact portion 51 configured to be in contact with a stylus of the printer 200. In the operation of mounting the chip 100 to the printer 200, rest portion of the grounding terminal 5 may also pass through the stylus of the printer 200. However, after the chip 100 is mounted in place, the ground wire contact portion 51 may be in contact with the stylus and then electrical connection may be achieved.

The conductive terminals include a first conductive terminal 1 and a second conductive terminal 2. Exemplarily, the conductive terminals may further include a third conductive terminal 3 and a fourth conductive terminal 4. The first conductive terminal 1 and the second conductive terminal 2 are located on the substrate 10 and spaced apart from each other. The first conductive terminal 1 and the second conductive terminal 2 may be substantially arranged along a Y-axis direction, i.e., a first direction. It may be understood that the first conductive terminal 1 and the second conductive terminal 2 may be misaligned in the X-axis direction, i.e., a second direction. Each of the conductive terminals includes a contact portion configured to be in electrical connection with the stylus of the printer 200. The first conductive terminal 1 may include a first contact portion 11 configured to be electrically connected to the stylus of the printer 200, and the second conductive terminal 2 may include a second contact portion 21. Exemplarily, the third conductive terminal 3 may include a third contact portion 31, and the fourth conductive terminal 4 may include a fourth contact portion 41.

Exemplarily, the first conductive terminal 1 and the grounding terminal 5 may be arranged along the X-axis direction and may be aligned in a row. A distance between the first contact portion 11 and the second contact portion 21 is less than that between the ground contact portion 51 and either of the first contact portion 11 and the second contact portion 21. Referring to FIG. 1, these conductive terminals may be located in the left half region of the substrate 10, i.e., the second half region B, and the grounding terminal 5 may be located in the right half region of the substrate 10, i.e., the first half region A. In an alternative embodiment, the quantity of the conductive terminals is four, and the quantity of the grounding terminal 5 is one.

The testing portion 6 is located on the substrate 10, and the testing portion 6 may also be exposed to the operating surface of the substrate 10. The testing portion 6 is electrically connected to the grounding terminal 5. Exemplarily, the testing portion 6 may include a grounding line segment 60. The grounding line segment 60 may be connected to the grounding terminal 5 and have a shape extending away from the grounding terminal 5.

The testing portion 6 includes a first testing line segment 61 located between the first conductive terminal 1 and the second conductive terminal 2. The first testing line segment 61 may be electrically connected to the grounding terminal 5 indirectly. For example, the first testing line segment 61 may be electrically connected to the grounding terminal 5 through the grounding line segment 60 or through other routes. Referring to FIG. 1, the first testing line segment 61 may be electrically connected to the grounding terminal 5 through a fifth testing line segment 65 and the grounding line segment 60. The first testing line segment 61 is spaced apart from each of the first conductive terminal 1 and the second conductive terminal 2.

The chip 100 may be adapted to be electrically connected to an external device. For example, the grounding terminal 5 and these conductive terminals may be in contact with styluses of the external device to establish electrical connections. In some cases, for example, when the chip 100 is taken as an ink cartridge chip, ink may be dripped to the chip 100, which may cause the first conductive terminal 1 and the second conductive terminal 2 to be short-circuited. Since the first testing line segment 61 of the testing portion 6 is located between the first conductive terminal 1 and the second conductive terminal 2, ink drops causing the first conductive terminal 1 and the second conductive terminal 2 to be short-circuited may also cover the first testing line segment 61. Then, since the first testing line segment 61 is electrically connected to the grounding terminal 5, each of the first conductive terminal 1 and the second conductive terminal 2 may be electrically connected to the grounding terminal 5.

At least one of the first conductive terminal 1 or the second conductive terminal 2 may transmit a high-voltage electrical signal during operation. However, after the first conductive terminal 1 and the second conductive terminal 2 are connected to the grounding terminal 5, output signals of the first conductive terminal 1 and the second conductive terminal 2 may become continuous low-voltage signals. This change in signal can be configured to characterize a possible short circuit fault between the first conductive terminal 1 and the second conductive terminal 2.

In the chip according to the present invention, faults caused by short circuits can be identified, thereby ensuring normal operation or rapid maintenance of the chip and external device. Meanwhile, operation safety of the chip can be ensured by directing the voltage to the grounding terminal through the testing portion, which prevents potential burnout due to high voltage at short-circuited locations.

In some embodiments, the external device may be configured to report an error alert according to an abnormal low-voltage signal of the conductive terminal, but such an error reporting function may be configured for situations such as improper mounting. However, the chip 100 according to the present invention may trigger an error alert in case of a short circuit between the conductive terminals by providing the testing portion 6. In this way, a fault identification system may be simplified and fault testing efficiency may be improved.

In some embodiments, the testing portion 6 may include a second testing line segment 62. Referring to FIG. 1, the second testing line segment 62 may be located at a side of the first conductive terminal 1 along the X-axis direction. For example, the second testing line segment 62 may be located at a right side of the first conductive terminal 1 in FIG. 1. The first testing line segment 61 may be located at a side of the first conductive terminal 1 along the Y-axis direction. For example, the first testing line segment 61 may be located at an upper side of the first conductive terminal 1 in FIG. 1. The second testing line segment 62 and the first testing line segment 61 may be located at two adjacent sides of the first conductive terminal 1, and the second testing line segment 62 and the first testing line segment 61 are configured to at least partially surround the first conductive terminal 1. The second testing line segment 62 may be electrically connected to the grounding terminal 5 through the grounding line segment 60.

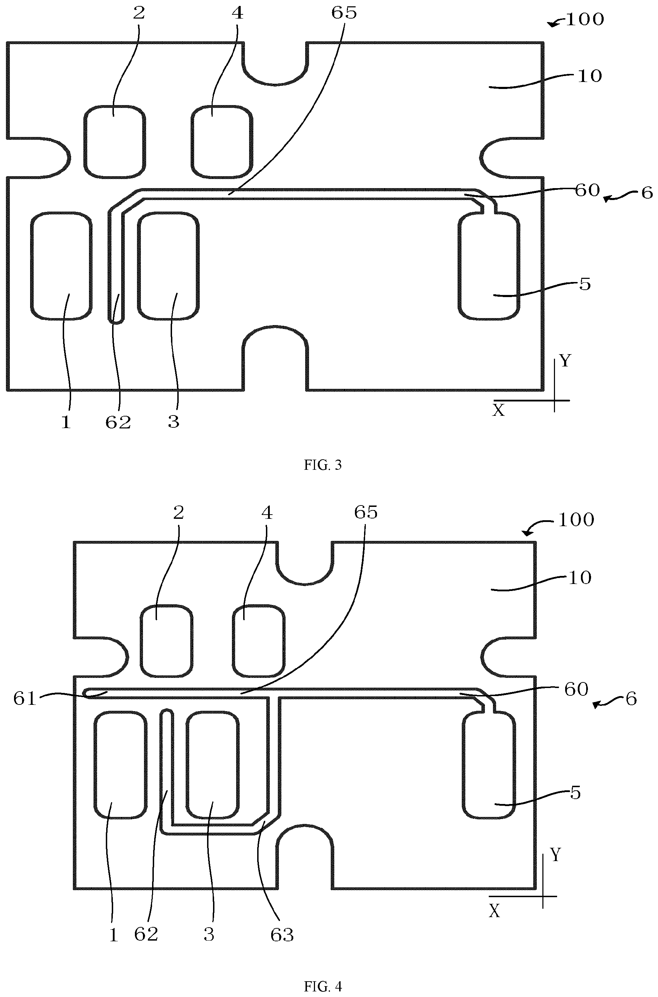

In some embodiments, the second testing line segment 62 may be electrically connected to the grounding line segment 60 through a fifth testing line segment 65. Referring to FIG. 4 and FIG. 5, in some other embodiments, the testing portion 6 may include a third testing line segment 63. The third testing line segment 63 may be electrically connected to the grounding terminal 5 through the grounding line segment 60. The second testing line segment 62 may be electrically connected to the grounding line segment 60 through the third testing line segment 63.

The third testing line segment 63 may be entirely located at a side of the third conductive terminal 3 facing away from the second conductive terminal 2. The third testing line segment 63 may cooperate with the second testing line segment 62 to surround the third conductive terminal 3, and the third testing line segment 63 may be arranged spaced apart from the third conductive terminal 3. It may be considered that the second conductive terminal 2 and the third conductive terminal 3 are separated by the first testing line segment 61. Therefore, the first testing line segment 61, in cooperation with the second testing line segment 62, may surround the third conductive terminal 3.

In an exemplary embodiment, a distance between the first testing line segment 61 and the first conductive terminal 1 may be the same as that between the first testing line segment 61 and the second conductive terminal 2. Exemplarily, the distance between the first testing line segment 61 and the first conductive terminal 1 may be substantially equivalent to a width of the first testing line segment 61. The first testing line segment 61 may be easy to form, which can ensure a controllable layout and a compact structure of the conductive terminals.

Referring to FIG. 1, exemplarily, a distance between the third contact portion 31 of the third conductive terminal 3 and the fourth contact portion 41 of the fourth conductive terminal 4 may be less than that between the ground wire contact portion 51 of the grounding terminal 5 and either of the third contact portion 31 and the fourth contact portion 41. The third conductive terminal 3 and the fourth conductive terminal 4 may be spaced apart along the Y-axis direction and may be laterally misaligned.

The third conductive terminals 3 and the grounding terminal 5 may be arranged in a row along the X-axis direction. Exemplarily, the first conductive terminal 1, the third conductive terminal 3 and the grounding terminal 5 may be sequentially arranged along the second direction, for example, arranged in a row. The second conductive terminal 2 and the fourth conductive terminal 4 may be sequentially arranged along the second direction, for example, arranged in a row. In an exemplary embodiment, the first contact portion 11 of the first conductive terminal 1 and the ground wire contact portion 51 of the grounding terminal 5 may be symmetric with respect to a boundary dividing the first half region A and the second half region B.

In some embodiments, the testing portion 6 may further include a second testing line segment 62 located between the first conductive terminal 1 and the third conductive terminal 3. The second testing line segment 62 may be spaced apart from the first conductive terminal 1 and spaced apart from the third conductive terminal 3. Referring to FIG. 1, the second testing line segment 62 may be indirectly electrically connected to the grounding terminal 5 through the grounding line segment 60. When the first conductive terminal 1 and the third conductive terminal 3 are short-circuited due to ink, the first conductive terminal 1 and the third conductive terminal 3 may be electrically connected to the grounding terminal 5 through the testing portion 6. A cooperation between the first testing line segment 61 and the second testing line segment 62 may further facilitate quick and effective identification of potential short circuit issues between the first conductive terminal 1 and the fourth conductive terminal 4.

Exemplarily, the first conductive terminal 1 may be covered by a projection of the second testing line segment 62 along the X-axis direction. In other words, a length of the second testing line segment 62 may be greater than that of the first conductive terminal 1 along the Y-axis direction, and the first conductive terminal 1 may be separated from the third conductive terminal 3 completely by the second testing line segment 62. The chip 100 may be mounted along the Y-axis direction. In addition, the chip 100 may enable comprehensive testing of the first conductive terminal 1, thereby helping to avoid risks caused by a short circuit between the first conductive terminal 1 and the third conductive terminal 3.

In some embodiments, the testing portion 6 may further include a fifth testing line segment 65 located between the third conductive terminal 3 and the fourth conductive terminal 4. The fifth testing line segment 65 may be spaced apart from the third conductive terminal 3 and spaced apart from the fourth conductive terminal 4. Referring to FIG. 1, the fifth testing line segment 65 may be electrically connected to the grounding terminal 5 through the grounding line segment 60. When the third conductive terminal 3 and the fourth conductive terminal 4 are short-circuited due to ink, the third conductive terminal 3 and the fourth conductive terminal 4 may be electrically connected to the grounding terminal 5 through the testing portion 6. A cooperation between the first testing line segment 61 and the fifth testing line segment 65 may further facilitate quick and effective identification of potential short circuit issues between the second conductive terminal 2 and the third conductive terminal 3.

In some embodiments, the testing portion 6 may include a fourth testing line segment 64 located between the second conductive terminal 2 and the fourth conductive terminal 4. The fourth testing line segment 64 may be spaced apart from each of the second conductive terminal 2 and the fourth conductive terminal 4. The fourth testing line segment 64 may be electrically connected to the grounding terminal 5 through the grounding line segment 60. When the second conductive terminal 2 and the fourth conductive terminal 4 are short-circuited due to ink, the second conductive terminal 2 and the fourth conductive terminal 4 may be electrically connected to the grounding terminal 5 through the testing portion 6. Exemplarily, the second conductive terminal 2 may be covered by a projection of the fourth testing line segment 64 along the X-axis direction. In other words, a length of the fourth testing line segment 64 may be greater than that of the second conductive terminal 2 along the Y-axis direction, and the second conductive terminal 2 may be separated from the fourth conductive terminal 4 completely by the fourth testing line segment 64.

Exemplarily, the first conductive terminal 1 may be a clock terminal, the second conductive terminal 2 may be a data terminal, the third conductive terminal 3 may be a power terminal, and the fourth conductive terminal 4 may be a reset terminal. **In** some embodiments, the testing portion 6 may include a grounding line segment 60, a first testing line segment 61, a second testing line segment 62, a fourth testing line segment 64, and a fifth testing line segment 65. The chip 100 may have a reliable circuit layout, and ensure comprehensive testing of the power terminal and the data terminal.

Exemplarily, the chip 100 may further include a detecting terminal (not shown). When the chip 100 is mounted on the printer 200, the detecting terminal may be electrically isolated from the stylus of the printer 200. The chip 100 may be detected before delivery or after use, and a detecting device may be electrically connected to the detecting terminal to obtain information or feedback from the chip 100.

FIG. 2 is a terminal layout of a chip according to the present invention. The chip 100 includes a substrate 10, a grounding terminal 5, a testing portion 6, and at least two conductive terminals. The testing portion 6 may include a grounding line segment 60, a first testing line segment 61, and a fifth testing line segment 65 located between the third conductive terminal 3 and the fourth conductive terminal 4. In some other embodiments, the fifth testing line segment 65 may be regarded as a part of the first testing line segment 61. Thereby, in such embodiments, both the second conductive terminal 2 and the fourth conductive terminal 4 may be located at a side of the first testing line segment 61, and both the first conductive terminal 1 and the third conductive terminal 3 may be located at another side of the first testing line segment 61. The chip 100 may have a simple circuit structure and enable effective testing of short circuits along the Y-axis direction.

FIG. 3 is a terminal layout of a chip according to the present invention. The chip 100 includes a substrate 10, a grounding terminal 5, a testing portion 6, and at least two conductive terminals. The testing portion 6 may include a grounding line segment 60, a fifth testing line segment 65, and a second testing line segment 62 located between the first conductive terminal 1 and the third conductive terminal 3. In some embodiments, the testing portion 6 may include a grounding line segment 60, a fifth testing line segment 65, and a second testing line segment 62. The chip 100 may have a simple circuit structure and enable effective testing of the third conductive terminal 3, for example, the power terminal.

FIG. 4 is a terminal layout of a chip according to the present invention. The chip 100 includes a substrate 10, a grounding terminal 5, a testing portion 6, and at least two conductive terminals. The testing portion 6 may include a grounding line segment 60, a first testing line segment 61, a second testing line segment 62, a third testing line segment 63, and a fifth testing line segment 65. The second testing line segment 62 may be electrically connected to the grounding terminal 5 through the third testing line segment 63 and the grounding line segment 60.

Referring to FIG. 1, FIG. 3, FIG. 4, and FIG. 5, in an exemplary embodiment, the testing portion 6 may surround the third conductive terminal 3 with a notch, and the chip 100 can operate stably. The second testing line segment 62 may be arranged spaced apart from the first testing line segment 61 along the Y-axis direction. In some other embodiments, the testing portion may continuously surround the third conductive terminal 3, and the third conductive terminal 3 may be comprehensively tested.

In some embodiments, the testing portion 6 may include a grounding line segment 60, a first testing line segment 61, a second testing line segment 62, a third testing line segment 63, and a fifth testing line segment 65. Exemplarily, a connecting position between the third testing line segment 63 and the fifth testing line segment 65 may be proximal to the third conductive terminal 3 and away from the grounding terminal 5. Potential short circuit issues on a side of the third conductive terminal 3 facing away from the fourth conductive terminal 4, as well as on a side of the third conductive terminal 3 facing away from the first conductive terminal 1 can be effectively tested by the third testing line segment 63.

For example, the chip 100 shown in FIG. 4 may be used and connected to the printer in the orientation illustrated. The third conductive terminal 3 may be located at a lower side of the fourth conductive terminal 4, and the third testing line segment 63 may include a segment located at a lower side of the third conductive terminal 3 and a segment located at a right side of the third conductive terminal 3. After the ink is dropped on the lower side or the right side of the third conductive terminal 3, the third conductive terminal 3 may be shorted to the grounding terminal 5 through the testing portion 6. In this case, the printer may report an error. This may enable early and accurate testing of abnormal ink drops existing on the upper side of the first conductive terminal 1, thereby preventing the ink drops from sliding onto other conductive terminals or the stylus of the printer, and thus avoiding potential damage to the printer.

FIG. 5 is a terminal layout of a chip according to the present invention. The chip 100 includes a substrate 10, a grounding terminal 5, a testing portion 6, and at least two conductive terminals. The testing portion 6 includes a grounding line segment 60, a first testing line segment 61, a second testing line segment 62, a third testing line segment 63, and a fifth testing line segment 65. The second testing line segment 62 may be electrically connected to the grounding terminal 5 through the third testing line segment 63 and the grounding line segment 60. A connecting position between the third testing line segment 63 and the fifth testing line segment 65 may be proximal to the grounding terminal 5 and away from the third conductive terminal 3. In this way, the third conductive terminal 3 may ensure stable and reliable electrical connection.

FIG. 6 is a block diagram of a printing system according to the present invention. The printing system may include a printer 200 and a consumable box detachably connected to each other. The consumable box includes the chip 100 mentioned above. The chip 100 may be electrically connected to the printer 200, for example, through electrical connections between the conductive terminals and the styluses of the printer 200.

Exemplarily, the chip 100 may further include a memory 30 and a processor, and the processor may include a first processor 20. The memory 30 may be electrically connected to the first processor 20. Each of the memory 30 and the first processor 20 may be electrically connected to the third conductive terminal 3, and may also be electrically connected to other conductive terminals such as the fourth conductive terminal 4.

The memory 30 may store information of the consumable box, such as an ink capacity, an ink type, a consumable box model, etc. The memory 30 may be electrically connected to a second processor 201 of the printer 200 through conductive terminals such as the second conductive terminal 2. The second processor 201 may be communicatively connected to the memory 30, and may identify information stored in the memory 30.

The first processor 20 is configured to process a signal of the fourth conductive terminal 4, and a signal of the third conductive terminal 3. Exemplarily, the first processor 20 is configured to send an error signal in response to the signal of the fourth conductive terminal 4 being an erroneous low voltage in a testing period, and send an error signal in response to the signal of the third conductive terminal 3 being an erroneous low voltage in the testing period. The printer 200 may report an error according to the error signal.

Referring to FIG. 6, the present invention provides a consumable box. The consumable box may include a box body containing ink and the foregoing chip. The substrate of the chip may be connected to the box body.

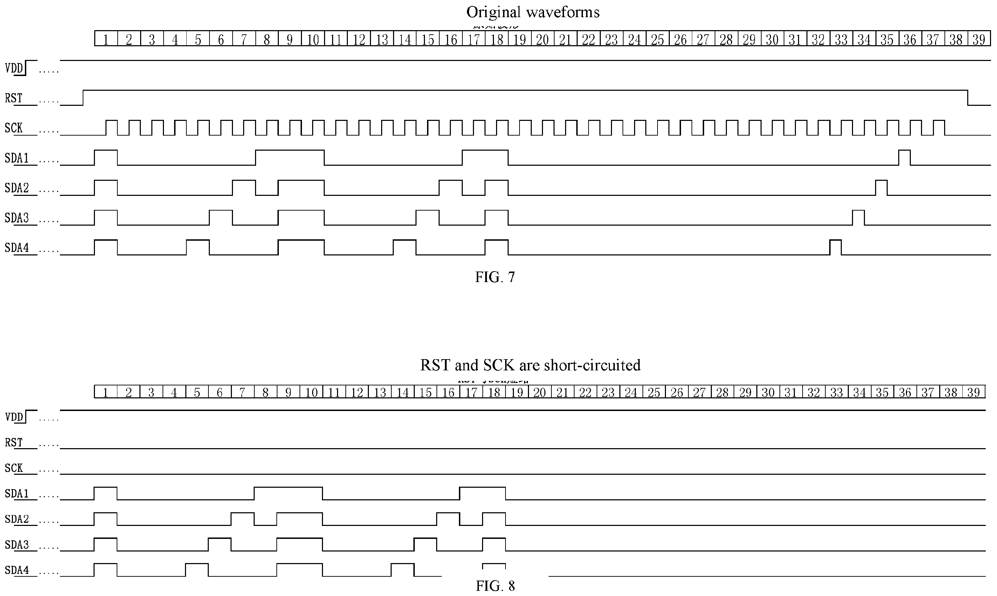

Referring to FIG. 7, when the chip 100 according to the present invention operates normally, a signal output by each of the conductive terminals may exhibit a normal waveform. Exemplarily, the chip 100 may include a power terminal, a reset terminal, a data terminal, a clock terminal, and a grounding terminal. Each of the power terminal, the reset terminal, the data terminal, the clock terminal, and the grounding terminal may be electrically connected to the memory 30 of the chip 100, may be referred to as a memory terminal, and may be electrically connected to the printer 200. The printer 200 may identify whether the signal output by each memory terminal is normal, and may perform normal operations according to normal waveforms. Referring to FIG. 7, after a voltage of a power signal VDD is pulled up, the chip 100 may undergo initialization. A voltage of a reset signal RST may be pulled up when the initialization is completed.

Voltage waveforms shown from the first byte to the 18th byte represent signals of the respective terminals during the acquisition of the short-circuit check signal. A clock signal SCK may exhibit a regular waveform, and a first data signal SDA1, a second data signal SDA2, a third data signal SDA3, and a fourth data signal SDA4 may correspond to signals of black (BK), cyan (C), magenta (M), and yellow (Y) consumable boxes, respectively. A ground wire signal GND may remain at a continuous low voltage.

Exemplarily, waveforms at the 19th byte correspond to a waiting period. The first processor 20 or the second processor 201 may be configured to designate the 33rd byte to the 36th byte as short-circuit testing bytes. Exemplarily, the 20th byte to the 39th byte may be configured as a check response period. The reset signal RST may be reduced to a low voltage at the 39th byte.

Referring to FIG. 7, from the 33rd byte to the 36th byte, the power signal VDD may remain at a high level throughout. The reset signal RST may remain consistently high. The clock signal SCK may cycle between low voltage and high voltage. The first data signal SDA1 may have a high level in a first half of the 36th byte and have a low level in the rest, and it may be considered that the chip 100 is free of short circuits. The second data signal SDA2 may have a high level in a first half of the 35th byte and have a low level in the rest, and it may be considered that the chip 100 is free of short circuits. The third data signal SDA3 may have a high level in a first half of the 34th byte and have a low level in the rest, and it may be considered that the chip 100 is free of short circuits. The fourth data signal SDA4 may have a high level in a first half of the 33rd byte and have a low level in the rest, and it may be considered that the chip 100 is free of short circuits.

In some other embodiments, a first half of the 29th byte may be defined as a first time t1, the first half of the 36th byte may be defined as a second time t2, and a second half of the 36th byte may be defined as a third time t3. Voltage data of each of the conductive terminals may be acquired at these three time points to determine which conductive terminals are short-circuited. Taking the normal waveforms shown in FIG. 7 as an example, at time t1, it may be acquired that each of the power signal VDD and the reset signal RST has a high voltage, and each of the clock signal SCK and the data signal has a low voltage. At time t2, it may be acquired that each of the power signal VDD and the reset signal RST has a high voltage, the clock signal SCK has a low voltage, and the first data signal SDA1 has a high voltage. At time t3, it may be acquired that each of the power signal VDD and the reset signal RST has a high voltage, the clock signal SCK has at high voltage, and the data signal has a low voltage. At this time, it may be determined that no short circuit occurs between the memory terminals. The second time t2 and the third time t3 vary for different color consumable boxes. Specifically, for SDA1, the first half of the 36th byte may be defined as the second time t2, and the second half of the 36th byte may be defined as the third time t3. For SDA2, the first half of the 35th byte may be defined as the second time t2, and a second half of the 35th byte may be defined as the third time t3. For SDA3, the first half of the 34th byte may be defined as the second time t2, and a second half of the 34th byte may be defined as the third time t3. For SDA4, the first half of the 33rd byte may be defined as the second time t2, and a second half of the 33rd byte may be defined as the third time t3.

During operation, the chip 100 according to the present invention may also distinguish short circuits occurring between different conductive terminals in other specific periods, and may not be limited to the fields described herein.

In some other embodiments, when it is tested that the voltage of the data terminal remains low from the 33rd byte to the 36th byte, it may be determined that the chip 100 has faults. For example, the printer 200 may report an error. Subsequently, it may be determined which conductive terminals are short-circuited by analyzing the voltage conditions of respective styluses.

FIG. 8 is waveforms of signals output by the chip 100 when the reset terminal and the clock terminal are short-circuited before the chip 100 is mounted to the printer 200. Since the reset terminal and the clock terminal can be electrically connected to the grounding terminal 5 through the testing portion 6, the voltages of the reset terminal and the clock terminal may remain consistently low from the 33rd byte to the 36th byte. As a result, the printer 200 will report an error, and it can be determined that a short circuit exists between the reset terminal and the clock terminal according to the waveform diagram. In another aspect, since the chip 100 cannot operate normally, the signal of the data terminal may remain low from the 20th byte to the 36th byte. That is, the data terminal may not output a signal in this period.

In other cases, for example, when a short circuit between the reset terminal and the clock terminal occurs only at the 31th byte due to ink leakage, the waveform from the 20th byte to the 30th byte may remain consistent with the original waveform, and not be pulled down until the 31th byte.

In some embodiments, the first half of the 29th byte may be defined as the first time t1, the first half of the 36th byte may be defined as the second time t2, and the second half of the 36th byte may be defined as the third time t3. At time t1, it may be acquired that the power signal VDD has a high voltage, each of the reset signal RST and the clock signal SCK has a low voltage, and each of data signals has a low voltage. At time t2, the power signal VDD has a high voltage, each of the reset signal RST and the clock signal SCK has a low voltage, and each of the data signals has a low voltage. At time t3, the power signal VDD has a high voltage, each of the reset signal RST and the clock signal SCK has a low voltage, and each of the data signals has a low voltage. At this time, it may be determined that the reset terminal and the clock terminal are short-circuited.

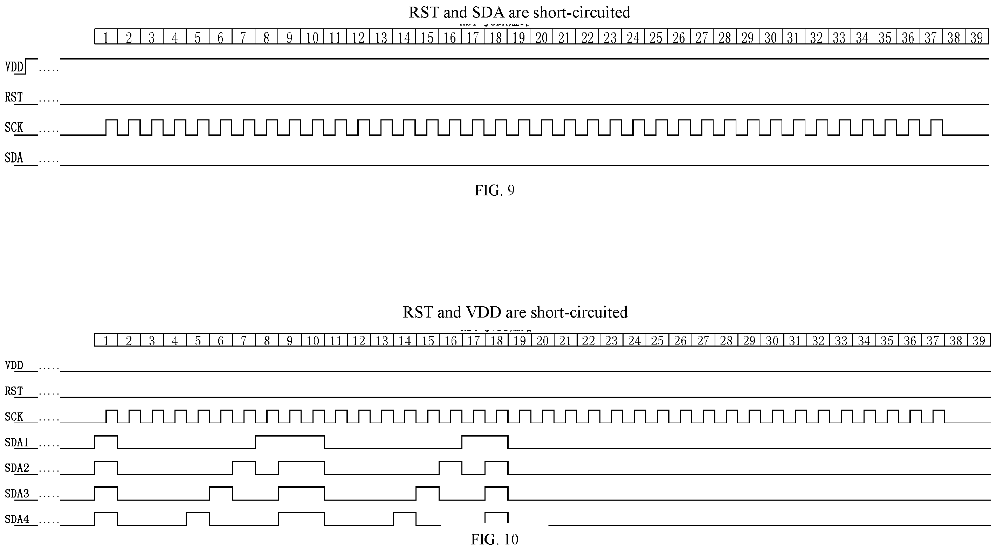

Exemplarily, when the reset terminal and the clock terminal are short-circuited before the chip 100 is mounted on the printer 200, the chip 100 may output signals having waveforms shown in FIG. 9. The reset signal RST of the reset terminal and the data signal SDA of the data terminal may remain consistently low. As a result, the printer 200 may report an error, and it may be determined that a short circuit exists between the reset terminal and the data terminal according to the waveform diagram. The waveform shown in FIG. 9 may result from the reset terminal and the data terminal being electrically connected to the grounding terminal 5 through the testing portion 6.

Referring to FIG. 10, after the reset terminal and the power terminal are short-circuited, both the reset terminal and the power terminal may be electrically connected to the grounding terminal 5 through the testing portion 6. The power signal VDD and the reset signal RST may remain at a low voltage from the beginning. The clock signal SCK may have a normal waveform. Since the chip 100 cannot function normally, the signal of the data terminal may remain at a low voltage from the 20th byte to the 36th byte. The printer 200 may report an error due to continuous low voltages of the reset signal RST and the power signal VDD from the 33rd byte to the 36th byte, and a specific short-circuit position may be determined according to the waveform diagram.

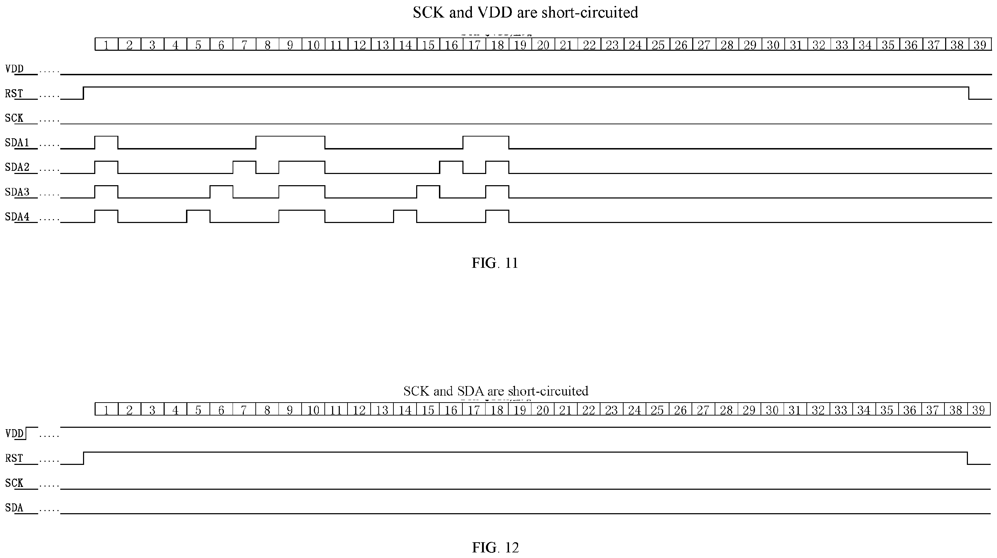

Referring to FIG. 11, after the clock terminal and the power terminal are short-circuited, both of the clock terminal and the power terminal may be electrically connected to the grounding terminal 5 through the testing portion 6. The power signal VDD and the clock signal SCK may remain at a low voltage from the beginning. The reset signal RST may be pulled up when the initialization is completed. Since the chip 100 cannot function normally, the signal of the data terminal may remain at a low voltage from the 20th byte to the 36th byte. The reset signal RST may drop to a low voltage at the 39th byte. The printer 200 may report an error due to continuous low voltages of the clock signal SCK and the power signal VDD from the 33rd byte to the 36th byte, and a specific short-circuit position may be determined according to the waveform diagram.

Referring to FIG. 12, after the clock terminal and the data terminal are short-circuited, both the clock terminal and the data terminal may be electrically connected to the grounding terminal 5 through the testing portion 6. After the voltage of the power signal VDD is pulled up, the chip 100 may undergo initialization, and the voltage of the reset signal RST may be pulled up when the initialization is completed. The clock signal SCK and the data signal SDA may remain at a low voltage. The printer 200 may report an error due to continuous low voltages of the clock signal SCK and the data signal SDA from the 33rd byte to the 36th byte, and a specific short-circuit position may be determined according to the waveform diagram. The reset signal RST may drop to a low voltage at the 39th byte.

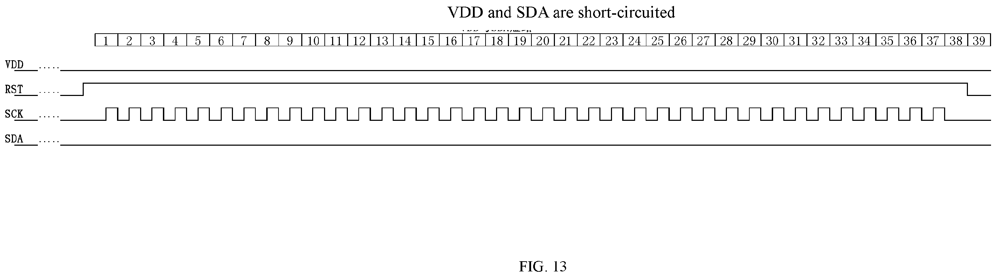

Referring to FIG. 13, after the power terminal and the data terminal are short-circuited, both the power terminal and the data terminal may be electrically connected to the grounding terminal 5 through the testing portion 6. The reset signal RST may be pulled up when the initialization is completed, and the clock signal SCK may have a normal waveform. The power signal VDD and the data signal SDA may remain at a low voltage. The printer 200 may report an error due to continuous low voltages of the power signal VDD and the data signal SDA from the 33rd byte to the 36th byte, and a specific short-circuit position may be determined according to the waveform diagram. The reset signal RST may drop to a low voltage at the 39th byte.

It may be understood that the chip, the consumable box and the printing system according to the present invention enable fault testing for different conductive terminals by a design of a shape of the testing portion.

In another variant embodiment, the first processor 20 of the chip 100 may be configured to detect the voltages of the memory terminals at the corresponding time points, and transmit a short-circuit signal/error signal or the like to the printer 200 in response to detecting an erroneous voltage, causing the printer 200 to stop operation.

Referring to FIG. 14, the present invention provides a consumable box 300, which may include a box body 310 and a chip 100. The box body 310 may have a bottom wall 301 and side walls including a first side wall 302. The chip 100 may be mounted on the first side wall 302.

The consumable box 300 may be mounted to, for example, a printer 200. In actual use, the Y-axis direction may be substantially a vertical direction. The bottom wall 301 may be downward, the first side wall 302 may be engaged with the printer 200, and the chip 100 may be electrically connected to the printer 200. Exemplarily, the consumable box 300 may include an ink outlet 303, which may be disposed on the bottom wall 301. Each of the side walls may be deflectable relative to the bottom wall 301, e.g., perpendicular to each other. The chip 100 may also be disposed on the bottom wall 301, depending on different consumable boxes.

In a printing process, issues such as ink leakage or sweat droplets from the user may occur. Exemplarily, when ink drips onto the chip 100, a short circuit may be caused, which in turn may cause damage to the chip 100 or the printer 200. The consumable box 300 according to the present invention can detect short-circuit issues, ensuring the normal operation and service life of the printing system.

Referring to FIG. 15, the boundary of the chip 100 configured for dividing the first half region and the second half region may be perpendicular to the bottom wall 301. The grounding terminal 5 may be located in the first half region. The first testing line segment 61 may extend along a horizontal direction, for example, the X-axis direction, separating the first conductive terminal 1 and the second conductive terminal 2 on upper and lower sides, respectively. Exemplarily, after ink contaminates the first conductive terminal 1, the ink may slide down due to gravity and form a connection with the second conductive terminal 2. The chip 100 according by the present invention, through the configuration of the testing portion 6, may enable timely pulling of an erroneous high voltage to a low voltage, thereby helping to prevent short-circuit faults or even burnout of the chip 100 or the printer 200 caused by a short circuit.

Exemplarily, the grounding terminal 5 and the second conductive terminal 2 may be disposed oppositely and separated by the first testing line segment 61. The grounding terminal 5 may be located at a side of the first testing line segment 61 proximal to the bottom wall 301, the second conductive terminal 2 may be located at a side of the first testing line segment 61 away from the bottom wall 301, and an extending direction of the first testing line segment 61 may be parallel to the bottom wall 301. The consumable box 300 may be detachably mounted to the printer 200 along the Y-axis direction, which helps to prevent the grounding terminal 5 from prematurely contacting possible ink drops. The testing portion 6 may be configured to separate the conductive terminals into upper and lower rows, while avoiding the styluses of the printer 200.

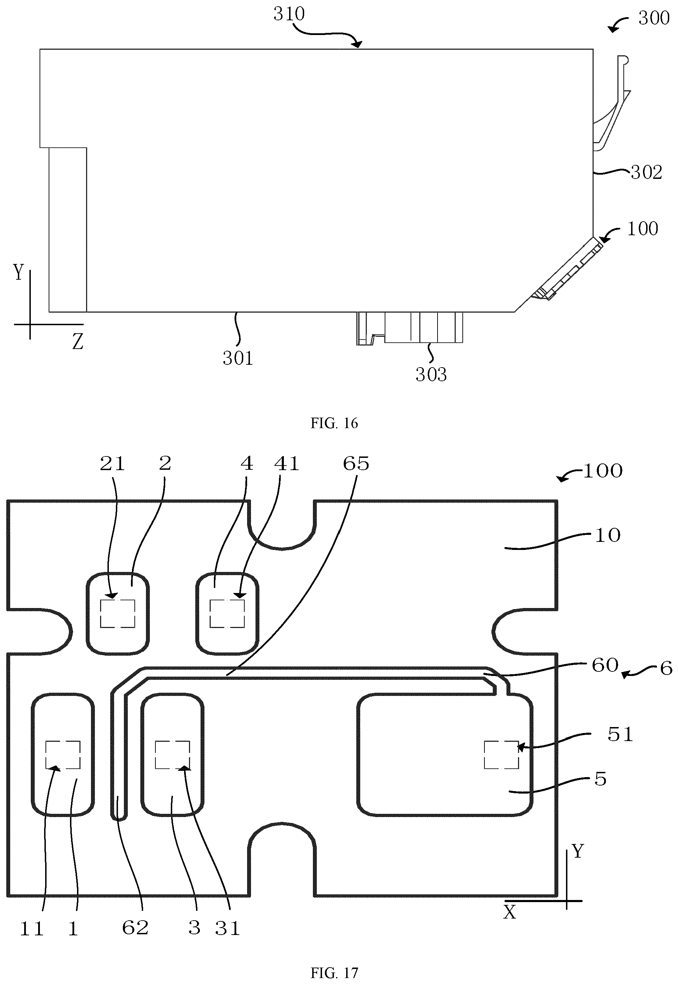

Referring to FIG. 16, the first side wall 302 may include a portion inclined relative to the bottom wall 301, and the chip 100 may be mounted on the inclined portion. Exemplarily, the boundary between the first half region and the second half region in the chip 100 may be parallel to a YZ plane. The first testing line segment 61 of the testing portion 6 may be substantially perpendicular to the YZ plane, separating the first conductive terminal 1 and the second conductive terminal 2 on upper and lower sides, respectively. Exemplarily, the grounding terminal 5 may be located at the lower side of the first testing line segment 61. The consumable box 300 may also be detachably mounted to the printer 200 along the Y-axis direction, and the mounting process may include, for example, rotation.

Referring to FIG. 17, each terminal of the chip 100 may adopt other shapes. For example, the grounding terminal 5 may have a relatively large area, while the position of the ground wire contact portion 51 may remain unchanged. Exemplarily, the ground wire contact portion 51 and the first contact portion 11 may be symmetrically arranged with respect to the central axis of the chip 100. In this way, the ground wire contact portion 51 and the first contact portion 11 may be at the same height along the Y-axis direction.

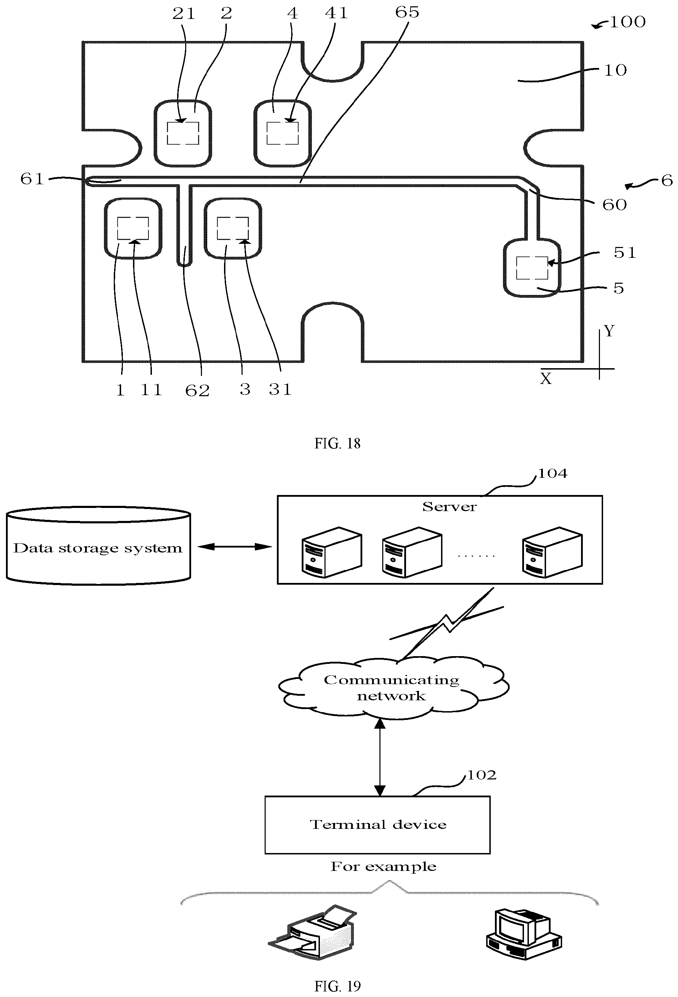

Referring to FIG. 18, in some other embodiments, the position of the ground wire contact portion 51 may be correspondingly moved downward or upward by adding positioning holes, limiting walls or the like to the chip 100. In this way, the ground wire contact portion 51 and the first contact portion 11 may be at different heights along the Y-axis direction. That is, the ground wire contact portion 51 and the first contact portion 11 may be asymmetrically arranged with respect to the central axis of the chip 100. An actual arraying or connecting direction of the ground contact portion 51 and the first contact portion 11 may be intersected with the X-axis direction. In other words, a connecting line between the ground line contact portion 51 and the first contact portion 11 may not be parallel to that between the second contact portion 21 and the fourth contact portion 41. Referring to FIG. 18, a connecting line between the third contact portion 31 and the ground wire contact portion 51 may also be intersected with rather than be parallel to that between the second contact portion 21 and the fourth contact portion 41.

A chip short-circuit check method provided in embodiments of the present invention may be applied to an application scenario shown in FIG. 19. FIG. 19 is a schematic diagram of an application scenario of a chip short-circuit check method according to an embodiment of the present invention. A terminal device 102 may communicate with the server 104 via a network. A data storage system may store data to be processed by the server 104. The data storage system may be integrated on the server 104, or may be deployed on a cloud or another network server. The terminal device 102 may be, but is not limited to, various devices such as fax machines and printers. The server 104 may be implemented by a standalone server or a server cluster including a plurality of servers.

This embodiment provides a chip short-circuit check method, including step 1 to step 4.

Step 1 includes acquiring a short-circuit check signal.

Exemplarily, the short-circuit check signal may be transmitted by a printing device to facilitate short-circuit check performed by a chip of a consumable box in cooperation with the printer prior to communication between the printing device and the chip of the consumable box.

Step 2 includes setting desired level signals for a first terminal in a to-be-tested chip at specified time points in a check response period based on the short-circuit check signal.

The to-be-tested chip may include a plurality of terminals such as a data terminal, a power terminal, a clock terminal, a reset terminal, and a grounding terminal. Alternatively, the first terminal is the data terminal.

Step 3 includes acquiring actual output level signals of the first terminal after the desired level signals are set for the first terminal.

Step 4 includes determining a short-circuit check result of the to-be-tested chip based on the actual output level signals. The short-circuit check result indicates that the to-be-tested chip functions normally although a short circuit between the second terminal and at least one terminal other than the second terminal exists in the to-be-tested chip, the to-be-tested chip functions normally and is free of short circuits, or the to-be-tested chip is functionally damaged.

**In** the aforementioned implementation, it may be effectively determined whether the function of the to-be-tested chip is damaged according to whether the actual output level signals of the first terminals are consistent with the desired level signals, thereby preventing erroneous determination of the short-circuit check result in a short-circuit check process of the to-be-tested chip.

When the actual output level signals are inconsistent with the desired level signals, it may be determined that the short-circuit check result indicates that the to-be-tested chip is functionally damaged.

When the actual output level signals are consistent with the desired level signals, it may be determined that the to-be-tested chip functions normally, and the method may further include step 1 to step 4.

Step 1 includes determining whether a voltage of a second terminal of the to-be-tested chip is continuously within a preset voltage range in the check response period;

Step 2 includes determining that no short circuit exists in the to-be-tested chip when the voltage of the second terminal of the to-be-tested chip is continuously within the preset voltage range in the check response period.

Step 3 includes determining that a short circuit between the second terminal and at least one terminal other than the second terminal exists in the to-be-tested chip when the voltage of the second terminal of the to-be-tested chip is not continuously within the preset voltage range in the check response period.

Specifically, after it is determined that the to-be-tested chip functions normally, it may be further determined whether the voltage of the second terminal of the to-be-tested chip is continuously within the preset voltage range in the check response period. **In** response to that the voltage of the second terminal of the to-be-tested chip is continuously within the preset voltage range in the check response period, it may be determined that the to-be-tested chip functions normally and is free of short circuits. **In** response to that the voltage of the second terminal of the to-be-tested chip is not continuously within the preset voltage range in the check response period, it may be determined that the to-be-tested chip functions normally although the second terminal and at least one terminal other than the second terminal are short-circuited.

The second terminal may be any terminal of the to-be-tested chip other than the first terminal. Alternatively, the second terminal may be the reset terminal.

**In** the aforementioned implementation, after it is determined that the to-be-tested chip functions normally, it may be accurately determined whether a short circuit between the reset terminal and other terminals exists in the to-be-tested chip according to a voltage state of the second terminal, so that the accuracy of the short-circuit check result of the to-be-tested chip may be improved.

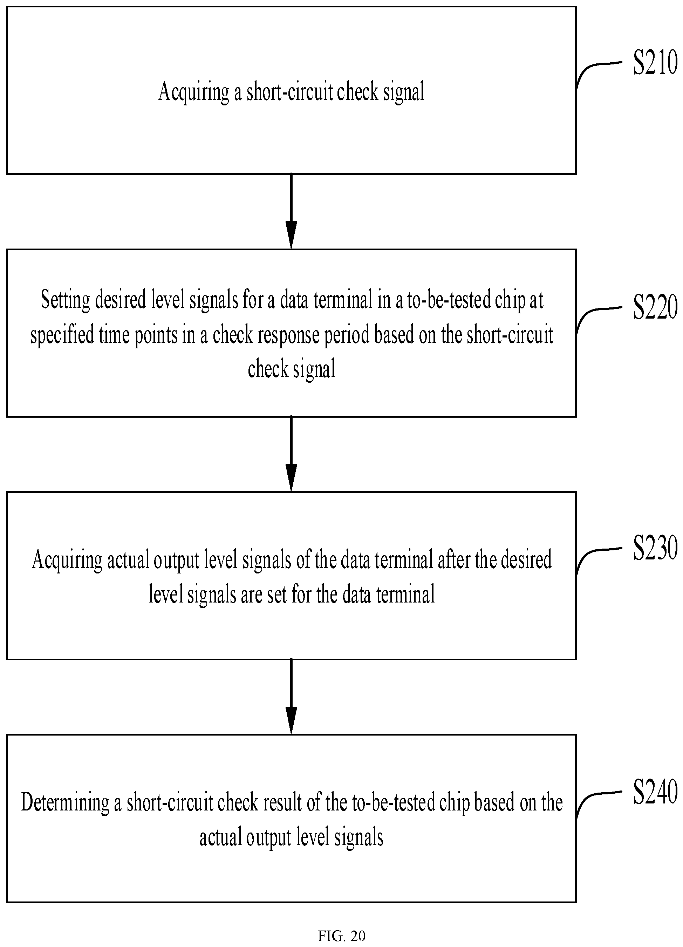

In an embodiment, a chip short-circuit check method is provided. FIG. 20 is a flowchart of a chip short-circuit check method according to an embodiment of the present invention, an execution subject of the method may be an electronic device. Alternatively, the electronic device may be a server, a terminal device, or a chip of a consumable box. Although the execution subject is described herein by taking the chip of the consumable cartridge as an example, the present invention is not limited thereto. Specifically, referring to FIG. 20, the flow includes the following step 210 to step 240.

Step 210 includes acquiring a short-circuit check signal.

Exemplarily, the short-circuit check signal may be transmitted by the printing device to facilitate short-circuit check performed by the chip of the consumable box in cooperation with the printer prior to communication between the printing device and the chip of the consumable box.

Step 220 includes setting desired level signals for a data terminal in a to-be-tested chip at specified time points in a check response period based on the short-circuit check signal.

Furthermore, the chip of the consumable box may perform the short-circuit check of the chip upon receiving the short-circuit check signal, and set the desired level signals for the data terminal in the to-be-tested chip at the specified time points in the response period of chip short-circuit check.

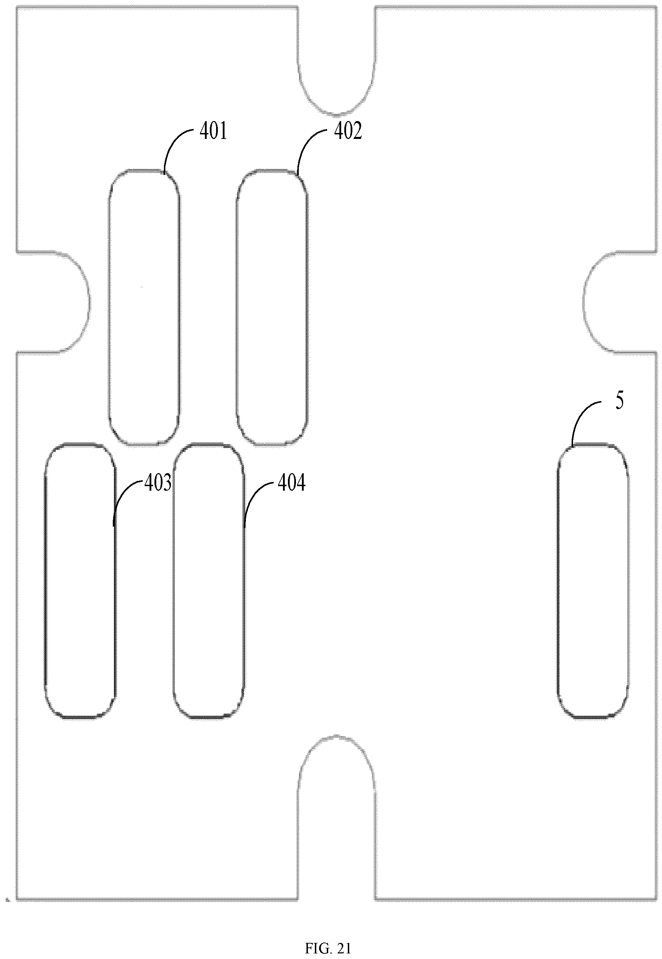

Specifically, the to-be-tested chip may be the chip of the consumable box to be checked. FIG. 21 is a schematic structural diagram of a to-be-tested chip according to an embodiment of the present invention. Referring to FIG. 21, the to-be-tested chip may include a memory (not shown) and a plurality of terminals including a data terminal 401, a power terminal 404, a clock terminal 403, a reset terminal 402, and a grounding terminal 5 each electrically connected to the memory. The memory is configured for storing related data required for the operation of the chip of the consumable box. The chip of the consumable box may set the desired level signals for the data terminal in the to-be-tested chip at the specified time points in the check response period upon receiving the short-circuit check signal. The desired level signals may have a "low-high-low" level sequence set at three different specified time points, respectively.

Step 230 includes acquiring actual output level signals of the data terminal after the desired level signals are set for the data terminal.

Step 240 includes determining a short-circuit check result of the to-be-tested chip based on the actual output level signals.

The short-circuit check result may indicate that the to-be-tested chip functions normally although a short circuit between the reset terminal and at least one terminal other than the reset terminal exists in the to-be-tested chip, the to-be-tested chip functions normally and is free of short circuits, or the to-be-tested chip is functionally damaged.

Furthermore, after the desired level signals are set for the data terminal, the level signals actually output by the data terminal may be acquired, so that the short-circuit check result of the to-be-tested chip may be determined according to the actually output level signals.

Specifically, after the desired level signals are set for the data terminal, when the to-be-tested chip functions normally, even if a short circuit between the reset terminal and any other terminal exists in the to-be-tested chip, the actual output of the data terminal may not be affected. That is, the actual output level signals of the data terminal may be consistent with the desired level signals. When the to-be-tested chip is functionally damaged, the actual output of the data terminal may be erroneous or the data terminal cannot output the level signal. **In** this case, the actual output level signals of the data terminal may be inconsistent with the desired level signals, so that a short-circuit check result of whether the to-be-tested chip is functionally damaged can be determined according to the actual output level signals of the data terminal.

In the aforementioned implementation, the chip may proceed to a short-circuit check phase upon receiving the short-circuit check signal, and set the desired level signals for the data terminal in the to-be-tested chip at the specified time points in the check response period of the short-circuit check phase. In this way, the short-circuit check result of whether the to-be-tested chip is functionally damaged can be determined according to the actual output level signals of the data terminal, thereby preventing an error in the short-circuit check result caused by the inability to determine whether the chip is functionally damaged in the short-circuit check process.

In some embodiments, determining the short-circuit check result of the to-be-tested chip based on the actual output level signals further includes: when the actual output level signals are inconsistent with the desired level signals, determining that the short-circuit check result indicates that the to-be-tested chip is functionally damaged.

Exemplarily, after the desired level signals are set for the data terminal, when the actual output level signals of the data terminal are inconsistent with the desired level signals, it may be determined that the to-be-tested chip is functionally damaged.

In the aforementioned implementation, it may be effectively determined whether the to-be-tested chip is functionally damaged according to whether the actual output level signals of the data terminal are consistent with the desired level signals, thereby avoiding errors in determining the short-circuit check result in the short-circuit check process of the to-be-tested chip.

In some embodiments, when the actual output level signals are consistent with the desired level signals, it may be determined that the to-be-tested chip functions normally, and the method may further include step 1 to step 3.

Step 1 includes determining whether a voltage of the reset terminal of the to-be-tested chip is continuously within a preset voltage range in the check response period.

Step 2 includes determining that no short circuit exists in the to-be-tested chip when the voltage of the reset terminal of the to-be-tested chip is continuously within the preset voltage range in the check response period.

Step 3 includes determining that a short circuit between the reset terminal and at least one terminal other than the reset terminal exists in the to-be-tested chip when the voltage of the reset terminal of the to-be-tested chip does not is not continuously within the preset voltage range in the check response period.

Exemplarily, when the actual output level signals are consistent with the desired level signals, it may be determined that the to-be-tested chip functions normally. Then, it may be further determined whether a short circuit exists in the to-be-tested chip under functionally normal conditions according to the voltage state of the reset terminal.

Specifically, after it is determined that the to-be-tested chip functions normally, it may be further determined whether the voltage of the reset terminal of the to-be-tested chip is continuously within the preset voltage range in the check response period. When the voltage of the reset terminal of the to-be-tested chip is continuously within the preset voltage range in the check response period, it can be determined that the to-be-tested chip functions normally and is free of short circuits. When the voltage of the reset terminal of the to-be-tested chip is not continuously within the preset voltage range in the check response period, it can be determined that the to-be-tested chip functions normally although the reset terminal and at least one terminal other than the reset terminal are short-circuited. The preset voltage range may be 1.78 V to 3.3 V, 1.65 V to 4 V, or other voltage ranges, which is not limited herein.

In an implementation, the preset voltage range may be defined as follows: the voltage of the reset terminal is low until 15 us before the waveform of the clock terminal is generated, and remains high throughout the communicating period and is below 3.3 V.

It should be noted that, generally, when the voltage of the data terminal at the corresponding specified time point is pulled up to 3.3 V or pulled down to 0 V, it may indicate that the data terminal is pulled up or pulled down. When the to-be-tested chip functions normally, in the check response period, when the voltage of the reset terminal is a high voltage and remains within the preset voltage range, it may indicate that the to-be-tested chip functions normally and is free of short circuits. Otherwise, it may be determined that the to-be-tested chip functions normally although the reset terminal and at least one terminal other than the reset terminal are short-circuited.

In the aforementioned implementation, after it is determined that the to-be-tested chip functions normally, it may be accurately determined whether a short circuit between the reset terminal and other terminals exists in the to-be-tested chip according to the voltage state of the reset terminal, so that the accuracy of the short-circuit check result of the to-be-tested chip may be improved.

In some embodiments, when the actual output level signals are consistent with the desired level signals, it may be determined that the to-be-tested chip functions normally, and the method may further include step 1 to step 3.

Step 1 includes determining whether the to-be-tested chip responds to a communicating command in a preset communicating period.

The communicating command may be transmitted by a printing device communicating with the to-be-tested chip, and the preset communicating period may be after the check response period.

Step 2 includes determining that the short-circuit check result indicates that the to-be-tested chip functions normally although the reset terminal and at least one terminal other than the reset terminal are short-circuited when the to-be-tested chip does not respond to the communicating command in the preset communicating period.

Step 3 includes determining that the short-circuit check result indicates that the to-be-tested chip functions normally and is free of short circuits when the to-be-tested chip responds to the communicating command in the preset communicating period.

Exemplarily, after it is determined that the to-be-tested chip functions normally, it may also be determined whether a short circuit exists in the to-be-tested chip according to whether the to-be-tested chip responds to the communicating command in the preset communicating period.

Generally, when the printing device communicates with the chip of the consumable box, the printing device may usually transmit the short-circuit check signal to the chip of the consumable box. The chip of the consumable box may proceed to a short-circuit check phase upon receiving the short-circuit check signal, and feed back short-circuit check data in the check response period in the short-circuit check phase for the printer to determine whether there is a short circuit. After the chip of the consumable box passes the short-circuit check, the printing device and the chip of the consumable box may proceed to a communicating phase. The communicating phase may be a preset communicating period. That is, the preset communicating period may be after the check response period. In the preset communicating period, the printing device may send the communicating command to the to-be-tested chip.

In the present embodiment, since the actual output level signals of the to-be-tested chip are consistent with the desired level signals, it may indicate that the to-be-tested chip has passed the short-circuit check in the short-circuit check phase. However, in practical scenarios, a short circuit may still exist between the reset terminal and at least one terminal other than the reset terminal. Therefore, after the printing device sends the communicating command, it may be determined whether a short circuit has occurred in the to-be-tested chip according to whether the to-be-tested chip responds to the communicating command.

When the to-be-tested chip does not respond to the communicating command in the preset communicating period, it may indicate that the to-be-tested chip has faults. However, since it has been determined that the to-be-tested chip functions normally in the short-circuit check phase, it may be determined that a short circuit between the reset terminal and at least one terminal other than the reset terminal exists in the to-be-tested chip. Correspondingly, when the to-be-tested chip responds to the communicating command in the preset communicating period, it may indicate that the to-be-tested chip functions normally and is free of short circuits.

In the aforementioned implementation, after it is determined that the to-be-tested chip functions normally, it may be determined whether a short circuit has occurred in the to-be-tested chip according to whether the to-be-tested chip responds to the communicating command in the preset communicating phase, thereby enabling the determination of the short-circuit check result of the to-be-tested chip and improving the accuracy of the short-circuit check result.

In some embodiments, setting the desired level signals for the data terminal in the to-be-tested chip at the specified time points in the check response period based on the short-circuit check signal may further include the following step1 to step 4.

Step 1 includes determining a plurality of clock time points of a clock terminal in the to-be-tested chip based on the short-circuit check signal.

Step 2 includes determining the check response period based on the plurality of clock time points.

Step 3 includes determining the specified time points corresponding to the data terminal in the to-be-tested chip in the check response period.

Step 4 includes setting the desired level signals at the specified time points corresponding to the data terminal.

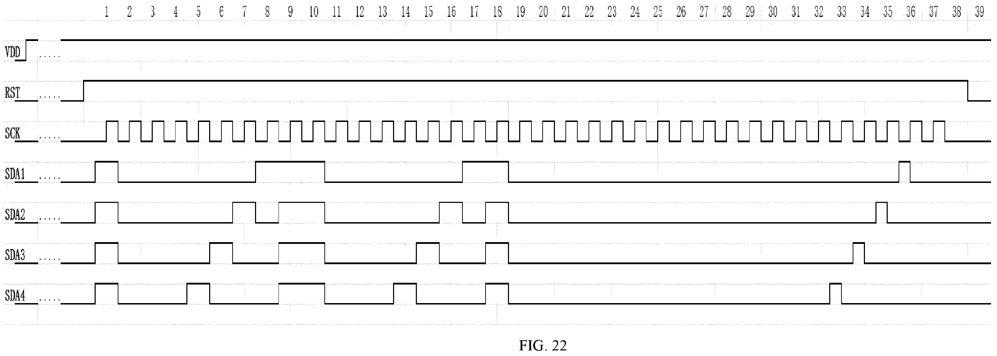

Exemplarily, the printing device may transmit a short-circuit check command having a signal waveform shown in FIG. 22. FIG. 22 is a complete short-circuit check waveform diagram of a chip under normal functional conditions and without any short circuit according to an embodiment of the present invention. Voltage waveforms from the first byte to the 18th byte may represent signals of the respective terminals during the acquisition of the short-circuit check signal. Waveforms at the 19th byte may correspond to a waiting period, and waveforms from the 20th byte to the 38th byte may correspond to a check response period. The voltage waveforms in the check response period may be the response voltage waveforms that can be obtained by the styluses of the printing device. A voltage waveform, i.e., a signal waveform of a terminal, may refer to a waveform presented over a period of time due to the terminal voltage being at a high level, a low level, or transitioning between the high level and the low level. A process of receiving the short-circuit check signal and feeding back the response voltage waveform may be defined as a short-circuit communicating check. In a specific embodiment, a total duration of the short-circuit check may be about 4.4 ms, which encompasses an entire period from the power signal VDD being pulled up to the power signal VDD being pulled down. The time allocated for the initialization of the chip may be 4.1785 ms, that is, a duration between a voltage pull-up time point of the power terminal and a voltage pull-up time point of the reset terminal. The signals from top to bottom in FIG. 22 may sequentially include: VDD representing the signal of the power terminal, RST representing the signal of the reset terminal, SCK representing the signal of the clock terminal, and each of the SDA1, SDA2, SDA3, and SDA4 representing the signal of the data terminal. The SDA1, SDA2, SDA3 and SDA4 signals may correspond to the signals of the K, C, M and Y color consumable boxes, respectively.

Therefore, upon receiving the short-circuit check signal, the to-be-tested chip may be determined to proceed to the short-circuit check phase. After proceeding to the short-circuit check phase, a plurality of clock time points corresponding to the 1st byte to the 38th byte in the clock terminal may be determined as the plurality of clock time points of the clock terminal. Among these time points, the period corresponding to the 20th to 38th byte may be defined as the check response period. Furthermore, taking the K-color consumable box as an example, a second half of the 27th byte and the 36th byte in the check response period may be determined as the specified time points corresponding to the data terminal, and the desired level signals may be set at these corresponding specified time points. Taking the C-color consumable box as an example, a second half of the 26th byte and the 35th byte in the check response period may be determined as the specified time points corresponding to the data terminal, and the desired level signals may be set at the corresponding specified time points. Taking the M-color consumable box as an example, a second half of the 25th byte and the 34th byte in the check response period may be determined as the specified time points corresponding to the data terminal, and the desired level signals may be set at the corresponding specified time points. Taking the Y-color consumable box as an example, a second half of the 24th byte and the 33rd byte in the check response period may be determined as the specified time points corresponding to the data terminal, and the desired level signals may be set at the corresponding specified time points.

Specifically, the desired level signals include a high-level signal and a low-level signal, levels of the grounding terminal and the power terminal may be taken as references for low and high levels, respectively. That is, a signal having a voltage of 0 V may be taken as the low-level signal, and a signal having a voltage of 3.3 V may be taken as the high-level signal.

In an implementation, a signal of 0.8 V may be considered as the low-level signal, and a signal of 3.2 V may be considered as the high-level signal. In another implementation, a signal below 1.78 V may be considered as the low-level signal, and a signal above 1.78 V may be considered as the high-level signal.

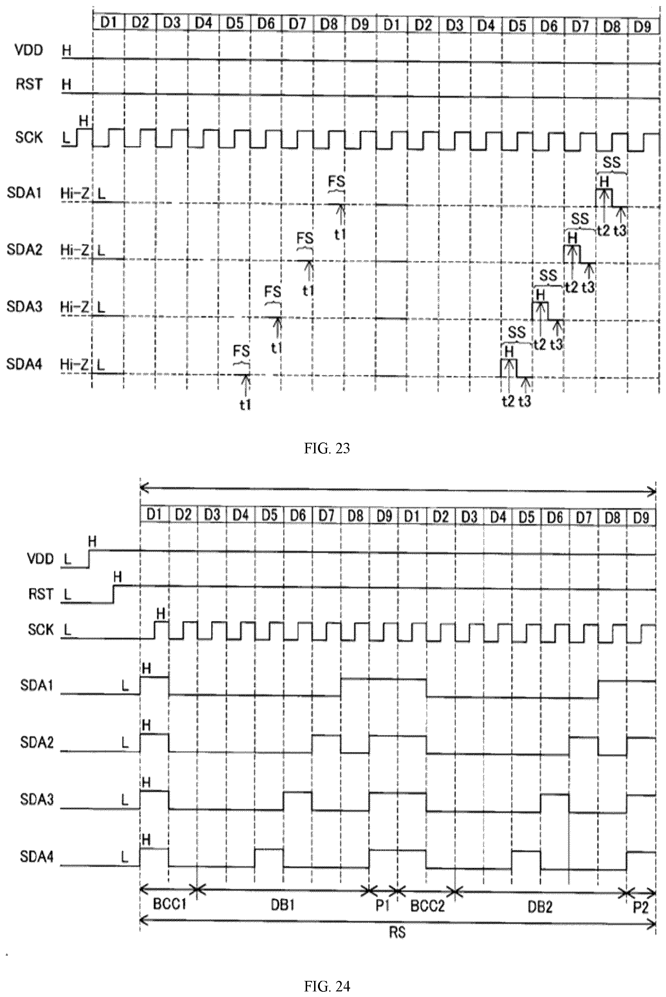

FIG. 23 is a schematic waveform diagram in a check response period provided by a printing device in the related art. The clock terminal corresponds to two segments each including nine clock time points, among which t1, t2, and t3 are specified time points at which the printing device tests the data terminal in the chip of the consumable box in the check response period. It is determined whether the chip of the consumable box passes the short-circuit check by testing level signals at the time points t1, t2, and t3. Specifically, referring to FIG. 23, when the level signals at the time points t1, t2, and t3 are low-high-low respectively, it is determined that the chip of the consumable box is free of short circuits. At this time, the printer does not report an error in the short-circuit check phase, which means that no short circuit exists in the chip of the consumable box. However, when the chip of the consumable box is functionally damaged although no short circuit exists in the chip, based on the above determination principle, since the printing device fails to test the low-high-low sequence of data level signals at time points t1, t2, and t3, the printer may report an error in the short-circuit check phase. Consequently, it is impossible to accurately distinguish whether the error is due to a short circuit or functional damage of the chip.

To resolve the foregoing problem, in some embodiments, the specified time points may include a first specified time point, a second specified time point, and a third specified time point, the first specified time point may be earlier than the second specified time point, and the second specified time point may be earlier than the third specified time point. In addition, setting the desired level signals at the specified time points corresponding to the data terminal may further include: setting a low-level signal at the first specified time point corresponding to the data terminal, setting a high-level signal at the second specified time point corresponding to the data terminal, and setting a low-level signal at the third specified time point corresponding to the data terminal.

Specifically, referring to FIG. 22, each of the first data signal SDA1, the second data signal SDA2, the third data signal SDA3 and the fourth data signal SDA4 of the data terminal may correspond to three specified time points, including a first specified time point t1, a second specified time point t2, and a third specified time point t3. Corresponding to the waveform diagram of this embodiment referring to FIG. 22, from the check response period: for SDA1, the second half of the 27th byte may be determined as the corresponding first specified time point t1, the first half of the 36th byte may be determined as the corresponding second specified time point t2, and the second half of the 36th byte may be determined as the corresponding third specified time point t3. For SDA2, the second half of the 26th byte may be determined as the corresponding first specified time point t1, the first half of the 35th byte may be determined as the corresponding second specified time point t2, and the second half of the 35th byte may be determined as the corresponding third specified time point t3. For SDA3, the second half of the 25th byte may be determined as the first corresponding specified time point t1, the first half of the 34th byte may be determined as the corresponding second specified time point t2, and the second half of the 34th byte may be determined as the corresponding third specified time point t3. For SDA4, the second half of the 24th byte may be determined as the corresponding first specified time point t1, the first half of the 33rd byte may be determined as the corresponding second specified time point t2, and the second half of the 33rd byte may be determined as the corresponding third specified time point t3.

In addition, each signal may be output as a low-level signal at the first time point t1, as a high-level signal at the second time point t2, and as a low-level signal at a third time point t3, so that each of the SDA1, SDA2, SDA3 and SDA4 may be output as a signal having a "low-high-low" level sequence.

In the aforementioned implementation, since the desired level signals are output at three specified time points for each signal of the data terminal, the to-be-tested chip may pass the related short-circuit check of the printing device, and the printer may not report an error in the short-circuit check. However, when the to-be-tested chip is functionally damaged, it may be unable to output the desired level signals. In this case, the printer may report an error in the short-circuit check, thereby effectively determining whether the to-be-tested chip is functionally damaged.

In some embodiments, acquiring the short-circuit check signal may further include the following step 1 to step 2.

Step 1 includes acquiring original waveform data transmitted by a printing device.

Step 2 includes determining the original waveform data as the short-circuit check signal when the original waveform data has a short-circuit check identifier.

Exemplarily, FIG. 24 is a schematic diagram of an original waveform of a short-circuit check signal transmitted by a printing device in the related art. A communicating command between the printing device and the chip of the consumable box may include a normal communicating command or a short-circuit check signal. After receiving the original waveform data transmitted by the printing device, the chip of the consumable box may determine whether the currently received waveform is corresponding to the short-circuit check signal by detecting whether the original waveform data has a short-circuit check identifier.

Specifically, when the first two bytes of the original waveform data transmitted by the printing device do not match fixed data transmitted for the normal communicating command by the printing device, the original waveform data may be identified as the short-circuit check signal. When a signal including the fixed data is identified as the short-circuit check signal, the to-be-tested chip may transmit a corresponding command to respond with corresponding data to the printing device at the corresponding time point, in order to pass the short-circuit check.

In the aforementioned implementation, it may be effectively determined whether the signal currently received by the to-be-tested chip is the short-circuit check signal by determining whether the short-circuit check identifier exists in the original waveform data. To some extent, this approach may avoid strict reliance on whether a format of the data transmitted by the printing device meets requirements for the chip to reply the short-circuit check data, thereby improving operational efficiency of the chip of the consumable box.

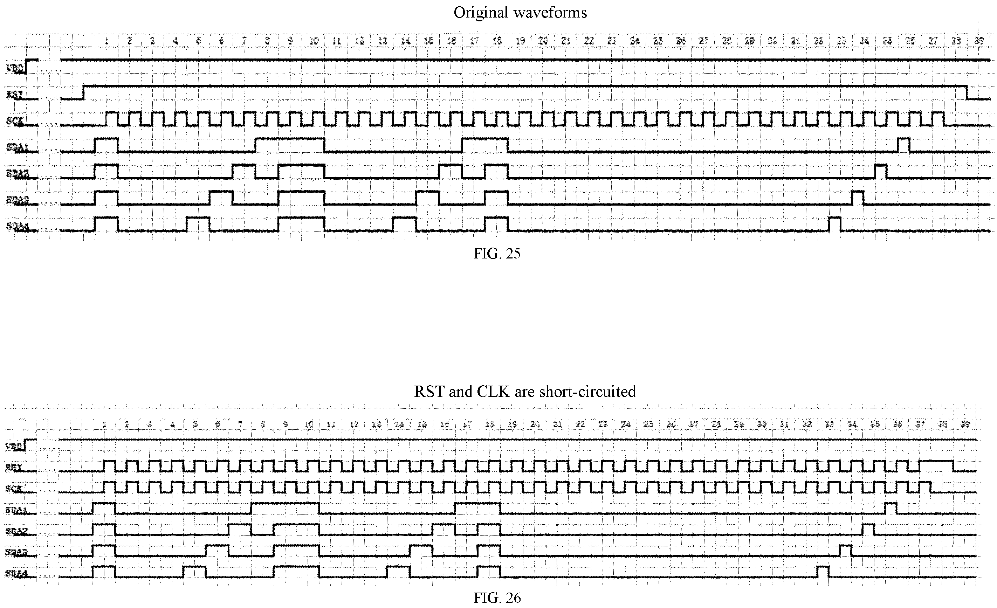

When the short-circuit check method of the present invention is applied, the original waveforms of respective terminals may refer to FIG. 25. FIG. 25 is a schematic diagram of an original waveform of each terminal according to an embodiment of the present invention. From the 20th byte to the 38th byte, the reset signal RST may remain consistently high, and the clock signal SCK may cycle between low voltage and high voltage. The first data signal SDA1 may have a high level in the first half of the 36th byte and have a low level in the rest. The second data signal SDA2 may have a high level in the first half of the 35th byte and have a low level in the rest. The third data signal SDA3 may have a high level in the first half of the 34th byte and have a low level in the rest. The fourth data signal SDA4 may have a high level in the first half of the 33rd byte and have a low level in the rest. At this point, it may be determined that the chips of the K, C, M and Y color consumable boxes are free of short circuits and function normally.

In an embodiment, when the reset terminal and the clock terminal are short-circuited, waveforms output by respective terminals of the to-be-tested chip in the short-circuit check method of the present invention may refer to FIG. 26. FIG. 26 is a schematic waveform diagram when the reset terminal and the clock terminal are short-circuited according to an embodiment of the present invention. During at least the 20th byte to the 38th byte, each of the reset signal RST and the clock signal may cycle between the low voltage and the high voltage. The first data signal SDA1 may have a high level in the first half of the 36th byte and have a low level in the rest. The second data signal SDA2 may have a high level in the first half of the 35th byte and have a low level otherwise. The third data signal SDA3 may have a high level in the first half of the 34th byte and have a low level in the rest. The fourth data signal SDA4 may have a high level in the first half of the 33rd byte and have a low level in the rest. At this point, since the desired level signals have been set for the data terminal in the to-be-tested chip at the specified time points in the response period of the chip short-circuit check, the data terminal, which would otherwise be unable to output the low-high-low level sequence at time points t1, t2, and t3, may output the low-high-low data level sequence referring to FIG. 26. As a result, the chip of the consumable box may function normally, and the printer may not report an error in the short-circuit check phase.

Specifically, when the reset terminal and the clock terminal are short-circuited, a weak driving capability of the reset terminal may cause the waveform of the reset terminal to be affected by the voltage on the clock terminal. As a result, the reset terminal may exhibit the same voltage as the clock terminal in the short-circuit period in which a short circuit occurs.

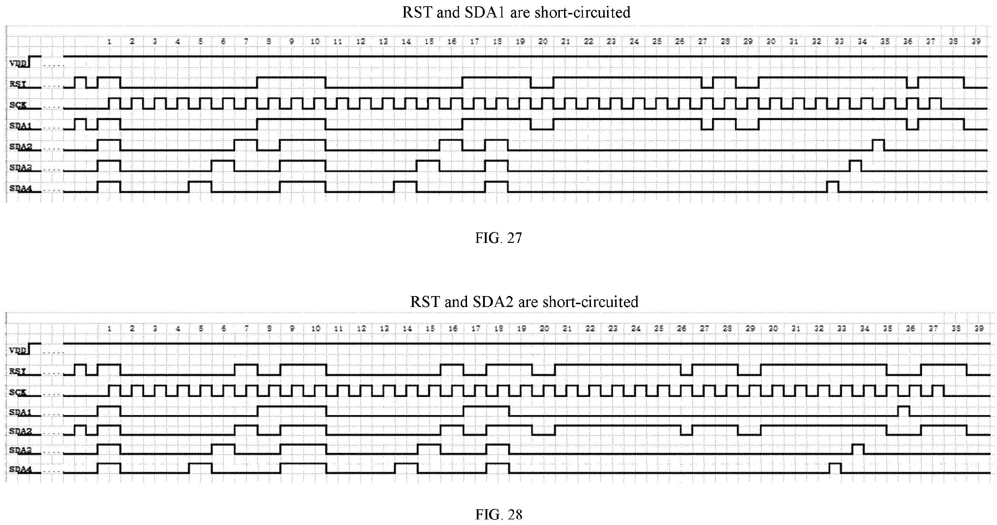

In an embodiment, when the reset terminal and the data terminal corresponding to the first data signal SDA1 are short-circuited, waveforms output by respective terminals of the to-be-tested chip in the short-circuit check method of the present invention may refer to FIG. 27. FIG. 27 is a schematic waveform diagram when the reset terminal and the data terminal corresponding to the first data signal SDA1 are short-circuited according to an embodiment of the present invention. From the 20th byte to the 38th byte, the reset terminal may maintain a low level during portions of these bytes due to the short circuit between the reset terminal and the data terminal. Specifically, the reset signal RST may have a low level at least in the second half of the 36th byte and the second half of the 27th byte. The clock signal SCK may cycle between the low voltage and the high voltage. The first data signal SDA1 may have a low level at least in the second half of the 36th byte and the second half of the 27th byte, and have a high level in the first half of the 36th byte. At this point, since the desired level signals have been set for the data terminal in the to-be-tested chip at the specified time points in the response period of the chip short-circuit check, the data terminal, which would otherwise be unable to output the low-high-low level sequence at time points t1, t2, and t3, may output the low-high-low data level sequence referring to FIG. 27. As a result, the chip of the consumable box may function normally, and the printer may not report an error in the short-circuit check phase.

In an embodiment, when the reset terminal and the data terminal corresponding to the second data signal SDA2 are short-circuited, waveforms output by respective terminals of the to-be-tested chip in the short-circuit check method of the present invention may refer to FIG. 28. FIG. 28 is a schematic waveform diagram when the reset terminal and the data terminal corresponding to the second data signal SDA2 are short-circuited according to an embodiment of the present invention. From the 20th byte to the 38th byte, the reset terminal may maintain a low level during portions of these bytes due to the short circuit between the reset terminal and the data terminal. Specifically, the reset signal RST may have a low level at least in the second half of the 35th byte and the second half of the 26th byte. The clock signal SCK may cycle between the low voltage and the high voltage. The second data signal SDA2 may have a low level at least in the second half of the 35th byte and the second half of the 26th byte, and have a high level in the first half of the 35th byte. At this point, since the desired level signals have been set for the data terminal in the to-be-tested chip at the specified time points in the response period of the chip short-circuit check, the data terminal, which would otherwise be unable to output the low-high-low level sequence at time points t1, t2, and t3, may output the low-high-low data level sequence referring to FIG. 28. As a result, the chip of the consumable box may function normally, and the printer may not report an error in the short-circuit check phase.

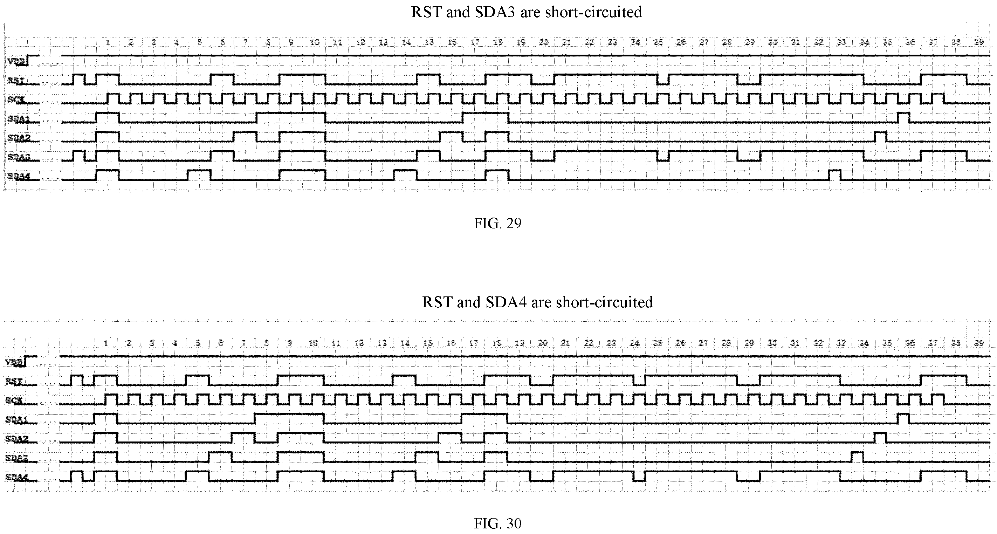

In an embodiment, when the reset terminal and the data terminal corresponding to the third data signal SDA3 are short-circuited, waveforms output by respective terminals of the to-be-tested chip in the short-circuit check method of the present invention may refer to FIG. 29.

FIG. 29 is a schematic waveform diagram when the reset terminal and the data terminal corresponding to the third data signal SDA3 are short-circuited according to an embodiment of the present invention. From the 20th byte to the 38th byte, the reset terminal may maintain a low level during portions of these bytes due to the short circuit between the reset terminal and the data terminal. Specifically, the reset signal RST may have a low level at least in the second half of the 34th byte and the second half of the 25th byte. The clock signal SCK may cycle between the low voltage and the high voltage. The third data signal SDA3 may have a low level at least in the second half of the 34th byte and the second half of the 25th byte, and have a high level in the first half of the 34th byte. At this point, since the desired level signals have been set for the data terminal in the to-be-tested chip at the specified time points in the response period of the chip short-circuit check, the data terminal, which would otherwise be unable to output the low-high-low level sequence at time points t1, t2, and t3, may output the low-high-low data level sequence referring to FIG. 29. As a result, the chip of the consumable box may function normally, and the printer may not report an error in the short-circuit check phase.

In an embodiment, when the reset terminal and the data terminal corresponding to the fourth data signal SDA4 are short-circuited, waveforms output by respective terminals of the to-be-tested chip in the short-circuit check method of the present invention may refer to FIG. 30. FIG. 30 is a schematic waveform diagram when the reset terminal and the data terminal corresponding to the fourth data signal SDA4 are short-circuited according to an embodiment of the present invention. From the 20th byte to the 38th byte, the reset terminal may maintain a low level during portions of these bytes due to the short circuit between the reset terminal and the data terminal. Specifically, the reset signal RST may have a low level at least in the second half of the 33rd byte and the second half of the 24th byte. The clock signal SCK may cycle between the low voltage and the high voltage. The fourth data signal SDA4 may have a low level at least in the second half of the 33rd byte and the second half of the 24th byte, and have a high level in the first half of the 33rd byte. At this point, since the desired level signals have been set for the data terminal in the to-be-tested chip at the specified time points in the response period of the chip short-circuit check, the data terminal, which would otherwise be unable to output the low-high-low level sequence at time points t1, t2, and t3, may output the low-high-low data level sequence referring to FIG. 30. As a result, the chip of the consumable box may function normally, and the printer may not report an error in the short-circuit check phase.

That is, when the reset terminal and the data terminal corresponding to any one of the first data signal SDA1, the second data signal SDA2, the third data signal SDA3, and the fourth data signal SDA4 are short-circuited, since the desired level signals have been set for the data terminal in the to-be-tested chip at the specified time points in the response period of the chip short-circuit check, the data terminal, which would otherwise be unable to output the low-high-low level sequence at time points t1, t2, and t3, may output the low-high-low data level sequence referring to FIG. 27, FIG. 28, FIG. 29, and FIG. 30, respectively. As a result, the chip of the consumable box may function normally, and the printer may not report an error in the short-circuit check phase. Meanwhile, when the reset terminal and the data terminal are short-circuited, the low-high-low reset signal sequence can also be detected on the reset terminal at time points t1, t2, and t3 due to the weak driving capability of the reset terminal.

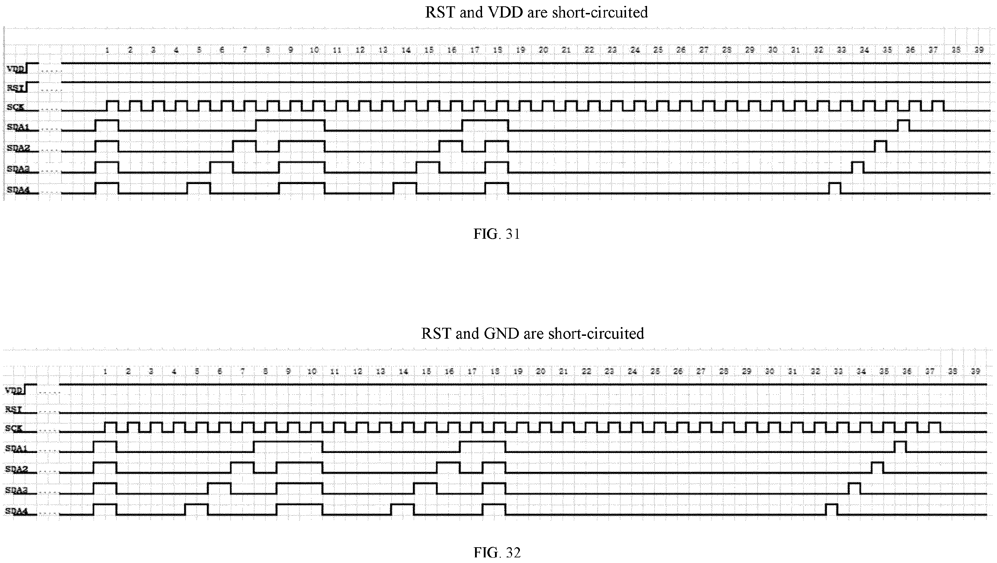

In an embodiment, when the reset terminal and the power terminal are short-circuited, waveforms output by respective terminals of the to-be-tested chip in the short-circuit check method of the present invention may refer to FIG. 31. FIG. 31 is a schematic waveform diagram when the reset terminal and the power terminal are short-circuited according to an embodiment of the present invention. Specifically, from the 20th byte to the 38th byte, the reset terminal may be pulled up earlier, simultaneously with the power terminal, while the power terminal may remain a high level. The data signal may have a low level at least at the time points t1 and t3, and have a high level at the time point t2. Meanwhile, since the desired level signals have been set for the data terminal in the to-be-tested chip at the specified time points in the response period of the chip short-circuit check, the data terminal, which would otherwise be unable to output the low-high-low level sequence at time points t1, t2, and t3, may output the low-high-low data level sequence referring to FIG. 31. As a result, the chip of the consumable box may function normally, and the printer may not report an error in the short-circuit check phase.

Specifically, when the reset terminal and the power terminal are short-circuited, the voltage of the reset terminal may be affected by the voltage on the power terminal due to the weaker driving capability of the reset terminal compared to that of the power terminal. **In** the short-circuit period, the voltage waveform of the reset terminal may be similar to that of the power terminal, showing a phenomenon where the voltage remains a fully high level. **In** the case of an early-stage short circuit, this may manifest as a premature occurrence of a high level, with the reset terminal still exhibiting a high level at the 39th byte.

**In** an embodiment, when the reset terminal and the grounding terminal are short-circuited, waveforms output by respective terminals of the to-be-tested chip in the short-circuit check of the present invention may refer to FIG. 32. FIG. 32 is a schematic waveform diagram when the reset terminal and the grounding terminal are short-circuited according to an embodiment of the present invention. From the 20th byte to the 38th byte, the reset terminal may maintain a low level. Each of the data signals may have a low level at least at the corresponding first and third time points t1 and t3, and have a high level at the corresponding second time point t2. Specifically, the voltage of the reset terminal may be pulled down from the original normal voltage to the grounding voltage due to the short circuit between the reset terminal and the grounding terminal. Meanwhile, since the desired level signals have been set for the data terminal in the to-be-tested chip at the specified time points in the response period of the chip short-circuit check, the data terminal, which would otherwise be unable to output the low-high-low level sequence at time points t1, t2, and t3, may output the low-high-low data level sequence referring to FIG. 32. As a result, the chip of the consumable box may function normally, and the printer may not report an error in the short-circuit check phase.

Specifically, due to the weaker driving capability of the reset terminal compared to the grounding terminal, the reset terminal may be affected by the grounding terminal, which results in that the voltage waveform of the reset terminal is similar to that of the grounding terminal in the short-circuit period, exhibiting a consistently low level state.

It can be understood that the diagrams in the various embodiments above illustrate the tested waveforms of the reset terminal and other terminals in scenarios where a short-circuit fault already exists before the short-circuit testing begins. When a short-circuit fault occurs during the short-circuit testing, the waveforms prior to the short-circuit may remain unaffected, while the waveforms after the short-circuit may change according to the specific scenarios.

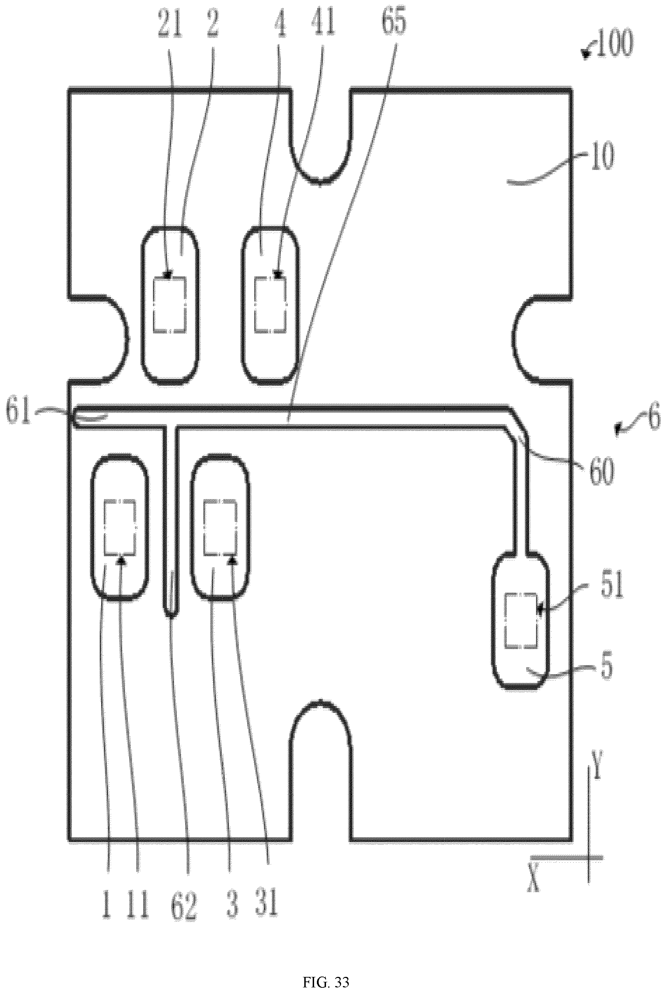

FIG. 33 is a schematic structural view of a to-be-tested chip provided with a testing portion according to an embodiment of the present invention. Referring to FIG. 33, the to-be-tested chip 100 may include a testing portion 6, a substrate 10, a grounding terminal 5, a first conductive terminal 1, a second conductive terminal 2, a third conductive terminal 3, and a fourth conductive terminal 4. The testing portion 6 is located on the substrate 10 and electrically connected to the grounding terminal 5. The testing portion 6 includes a first testing line segment 61, a second testing line segment 62, and a grounding line segment 60. The first testing line segment 61 is connected to the grounding terminal through the grounding line segment. The second conductive terminal 2 and the fourth conductive terminal 4 may be located at a side of the first testing line segment 61, and the first conductive terminal 1 and the third conductive terminal 3 may be located at another side of the first testing line segment 61. The second testing line segment 62 is connected to the first testing line segment 61, and the first conductive terminal 1 and the third conductive terminal 3 may be separated by the second testing line segment 62. The first testing line segment 61, the second testing line segment 62, and the grounding line segment 60 may include metal wires, respectively. Alternatively, the testing portion 6 may be made of other conductive materials such as carbon oil and rubber. The to-be-tested chip 100 may further include a memory (not shown). Each of the grounding terminal 5, the first conductive terminal 1, the second conductive terminal 2, the third conductive terminal 3, and the fourth conductive terminal 4 may be electrically connected to the memory. The first conductive terminal 1 may be a clock terminal, the second conductive terminal 2 may be a data terminal, the third conductive terminal 3 may be a power terminal, and the fourth conductive terminal 4 may be a reset terminal.

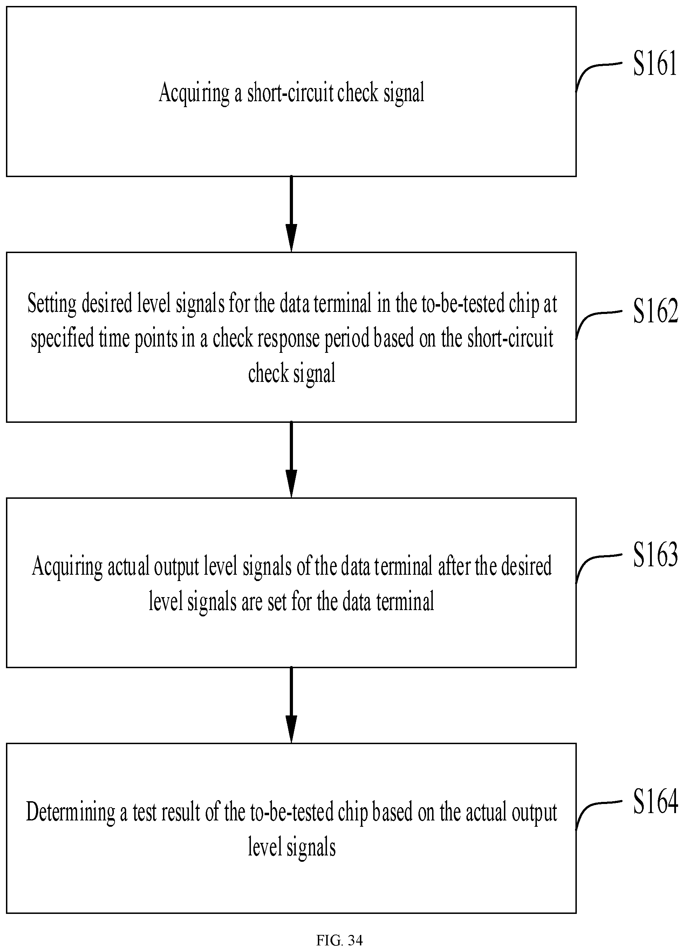

In an embodiment, a chip testing method is provided. This method may be applied to the to-be-tested chip referring to FIG. 33. FIG. 16 is a flowchart of a chip testing method according to an embodiment of the present invention. Referring to FIG. 34, the chip testing method includes step 161 to step 164.

Step 161 includes acquiring a short-circuit check signal.

Exemplarily, the short-circuit check signal may be transmitted from the printing device to the chip of the consumable box provided with the testing portion. The short-circuit check signal is configured for fault check performed by the chip of the consumable box in cooperation with the printer before communication is established between the printing device and the chip of the consumable box.

Step 162 includes setting desired level signals for a data terminal in a to-be-tested chip at specified time points in a check response period based on the short-circuit check signal.

Furthermore, the chip of the consumable box may perform the short-circuit check of the chip upon receiving the short-circuit check signal. The desired level signals may be set for the data terminal in the to-be-tested chip at the specified time points in the response period of chip short-circuit check. The chip of the consumable box may set the desired level signals for the data terminal in the to-be-tested chip at the specified time points in the check response period upon receiving the short-circuit check signal. The desired level signals may have a "low-high-low" level sequence set at three different specified time points, respectively.

Step 163 includes acquiring actual output level signals of the data terminal after the desired level signals are set for the data terminal.

Step 164 includes determining a test result of the to-be-tested chip based on the actual output level signals.

The test result of the to-be-tested chip indicates that the to-be-tested chip functions normally or the to-be-tested chip has faults.

Furthermore, after the desired level signals are set for the data terminal, the level signals actually output by the data terminal may be acquired, so that the fault test result of the to-be-tested chip may be determined according to the actually output level signals.

In the aforementioned implementation, by setting the desired level signals for the data terminal at the specified time points in the check response period, and determining the fault test result of the to-be-detected chip based on the actual output voltage of the data terminal, fault testing of the to-be-detected chip provided with the testing portion may be thereby enabled.

In some embodiments, determining the test result of the to-be-detected chip based on the actual output level signals may further includes step 1 and step 2.

Step 1 includes determining that the test result of the to-be-tested chip indicates that the to-be-tested chip functions normally when the actual output level signals are consistent with the desired level signals,

Step 2 includes determining that the test result of the to-be-tested chip indicates that the to-be-tested chip has the faults when the actual output level signals are inconsistent with the desired level signals, The faults of the to-be-tested chip may include at least one of a short circuit between remaining terminals of the to-be-tested chip other than the reset terminal, either or both of a short circuit between the reset terminal and the clock terminal and a short circuit between the reset terminal and the power terminal, a short circuit between any terminal other than the reset terminal and the testing portion, or a functional damage of the to-be-tested chip.

Specifically, when the actual output level signals of the data terminal are consistent with the desired level signals, it may indicate that the to-be-tested chip functions normally. When the actual output level signals are inconsistent with the desired level signals, it may indicate that the to-be-tested chip has faults. Potential causes of the faults may include at least one of a short circuit between remaining terminals of the to-be-tested chip other than the reset terminal, either or both of a short circuit between the reset terminal and the clock terminal and a short circuit between the reset terminal and the power terminal, a short circuit between any terminal other than the reset terminal and the testing portion, or a functional damage of the to-be-tested chip.

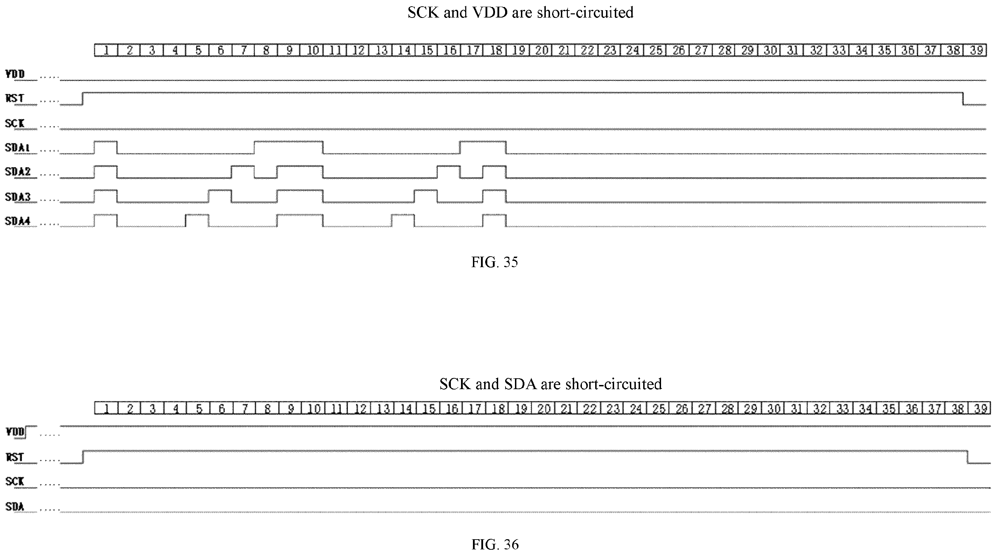

FIG. 35 is a schematic waveform diagram when the clock terminal and the power terminal are short-circuited according to the present invention. Referring to FIG. 35, after the clock terminal and the power terminal are short-circuited, both the clock terminal and the power terminal may be electrically connected to the grounding terminal 5 through the testing portion 6. The power signal VDD and the clock signal SCK may be pulled down from the normal voltage state shown in FIG. 22 to a consistently low voltage. Since the chip 100 cannot function normally, the signal of the data terminal may remain at a low voltage from the 20th byte to the 36th byte. At this point, the printing device or the chip of the consumable box may determine that the to-be-tested chip has faults due to at least one of the clock signal SCK, the power signal VDD or the data signal SDA remaining at a low voltage from the 33rd byte to the 36th byte, and may further determine a specific short-circuit position according to waveform characteristics. Meanwhile, the printer may report an error in the short-circuit check phase.

FIG. 36 is a schematic waveform diagram when the clock terminal and the data terminal are short-circuited according to an embodiment of the present invention. Referring to FIG. 36, after the clock terminal and the data terminal are short-circuited, both the clock terminal and the data terminal may be electrically connected to the grounding terminal 5 through the testing portion 6. After the voltage of the power signal VDD is pulled up, the chip 100 may undergo initialization. The voltage of the reset signal RST may be pulled up when the initialization is completed. Since each of the clock terminal and the data terminal is connected to the testing portion 6, the short-circuited clock signal SCK and data signal SDA may remain consistently at a low voltage. At this point, the printing device or the chip of the consumable box may determine that the to-be-tested chip has faults because each of the clock signal SCK and the data signal SDA remains at a low voltage from the 33rd byte to the 36th byte, and may further determine a specific short-circuit position according to waveform characteristics. Meanwhile, the printer may report an error in the short-circuit check phase.

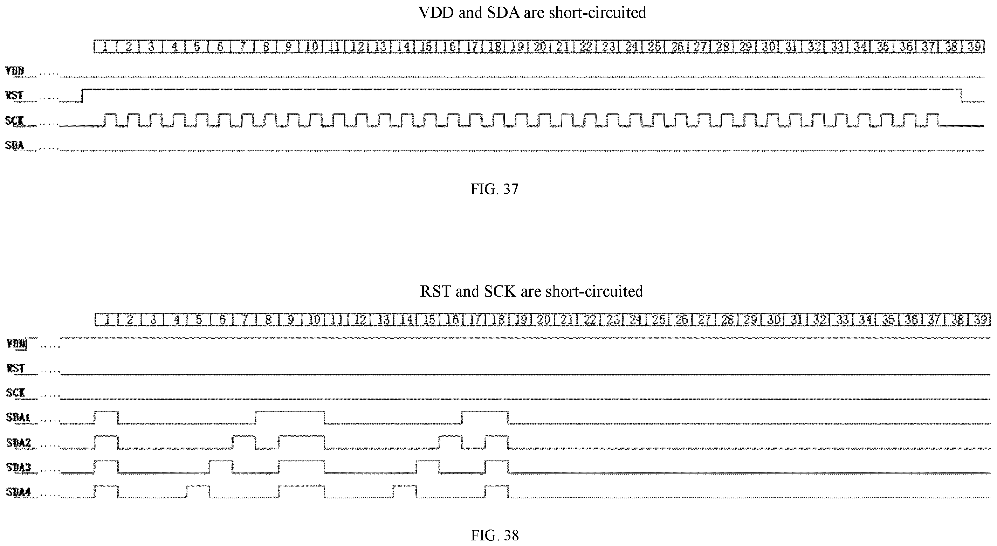

FIG. 37 is a schematic waveform diagram when the power terminal and the data terminal are short-circuited according to an embodiment of the present invention. Referring to FIG. 37, after the power terminal and the data terminal are short-circuited, both the power terminal and the data terminal may be electrically connected to the grounding terminal 5 through the testing portion 6. The reset signal RST may be pulled up when the initialization is completed, and the clock signal SCK may have a normal waveform. The power signal VDD and the data signal SDA may remain consistently at a low voltage. At this point, the printing device or the chip of the consumable box may determine that the to-be-tested chip has faults because at least one of the power signal VDD or the data signal SDA remains at a low voltage from the 33rd byte to the 36th byte, and may further determine a specific short-circuit position according to waveform characteristics. Meanwhile, the printer may report an error in the short-circuit check phase.

FIG. 38 is another schematic waveform diagram when the reset terminal and the clock terminal are short-circuited according to an embodiment of the present invention. Referring to FIG. 38, when the reset terminal and the clock terminal are short-circuited, the voltages of the reset terminal and the clock terminal may remain consistently low from the 33rd byte to the 36th byte because the reset terminal and the clock terminal may be electrically connected to the grounding terminal 5 through the testing portion 6. In addition, since the chip 100 cannot function normally, the signal of the data terminal may remain at a low voltage from the 20th byte to the 36th byte. At this point, the printing device or the chip of the consumable box may determine that the to-be-tested chip has faults because at least one of the reset signal RST, the clock signal SCK, or the data signal SDA remains at a low voltage from the 33rd byte to the 36th byte, and may further determine that the reset terminal and the clock terminal are short-circuited according to waveform characteristics. Meanwhile, the printer may report an error in the short-circuit check phase.

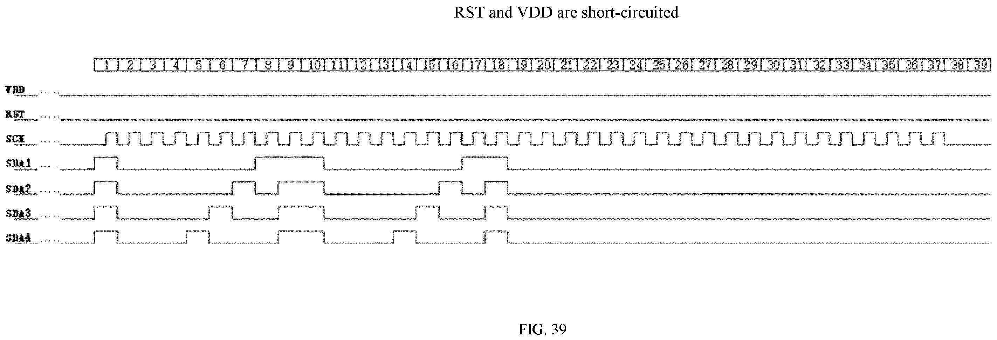

FIG. 39 is another schematic waveform diagram when the reset terminal and the power terminal are short-circuited according to the present invention. Referring to FIG. 39, after the reset terminal and the power terminal are short-circuited, both the reset terminal and the power terminal may be electrically connected to the grounding terminal 5 through the testing portion 6. The power signal VDD and the reset signal RST may remain consistently pulled down to have a low voltage from the beginning. The clock signal SCK may have a normal waveform. Since the chip 100 cannot function normally, the signal of the data terminal may remain at a low voltage from the 20th byte to the 36th byte. The printing device or the chip of the consumable box may determine that the to-be-tested chip has faults because at least one of the reset signal RST, the power signal VDD, or the data signal SDA remains at a low voltage from the 33rd byte to the 36th byte, and may further determine a specific short-circuit position according to waveform characteristics. Meanwhile, the printer may report an error in the short-circuit check phase.

In the aforementioned implementation, by comparing whether the actual output level signals of the data terminal are consistent with the desired level signals, it is possible to assist in testing whether the to-be-tested chip provided with the testing portion has a functional fault.

In some embodiments, when the actual output level signals are consistent with the desired level signals, the method may further include step 1 to step3.

Step 1 includes determining whether a voltage of the reset terminal of the to-be-tested chip is continuously within a preset voltage range in the check response period.

Step 2 includes determining that no short circuit exists in the to-be-tested chip when the voltage of the reset terminal of the to-be-tested chip is continuously within the preset voltage range in the check response period.

Step 3 includes determining that a short circuit between the reset terminal and the data terminal or a short circuit between the reset terminal and the grounding terminal exists in the to-be-tested chip when the voltage of the reset terminal of the to-be-tested chip is not continuously within the preset voltage range in the check response period.

Exemplarily, after it is determined that the to-be-tested chip functions normally, it may be determined whether the reset terminal is short-circuited with the data terminal or the grounding terminal according to the voltage of the reset terminal of the to-be-tested chip.

When the voltage of the reset terminal of the to-be-tested chip is continuously within the preset voltage range in the check response period, it may indicate that no short circuit has occurred in the to-be-tested chip. When the voltage of the reset terminal of the to-be-tested chip is not continuously within the preset voltage range in the check response period, it may indicate that a short circuit between the reset terminal and the data terminal, a short circuit between the reset terminal and the grounding terminal, or a short circuit between the reset terminal and the metal wire in the testing portion exists in the to-be-tested chip.

In the aforementioned implementation, after it is determined that the to-be-tested chip functions normally, it may be determined whether the reset terminal is short-circuited with the data terminal or the grounding terminal in the to-be-tested chip according to the voltage of the reset terminal in the check response period. This may enable precise identification of potential short-circuit conditions in the to-be-tested chip.

In some embodiments, when the actual output level signals are consistent with the desired level signals, the method may further include step 1 to step 3.

Step 1 includes determining whether the to-be-tested chip responds to a communicating instruction in a preset communicating period.

The communicating command may be transmitted by a printing device communicating with the to-be-tested chip. The preset communicating period may be after the check response period.

Step 2 includes determining that the short-circuit check result indicates that the to-be-tested chip functions normally although a short circuit between the reset terminal and the data terminal or the grounding terminal exists in the to-be-tested chip when the to-be-tested chip does not respond to the communicating command in the preset communicating period.

Step 3 includes determining that the short-circuit check result indicates that the to-be-tested chip functions normally and is free of short circuits when the to-be-tested chip responds to the communicating command in the preset communicating period.

It should be noted that although the steps in the flowcharts involved in the foregoing embodiments are displayed sequentially as indicated by the arrows, the steps are not necessarily executed in the order indicated by the arrows. Unless explicitly stated herein, there are no strict sequential constraints on the execution of these steps, which may be performed in other orders. In addition, at least some of the steps in the flowcharts involved in the foregoing embodiments may include a plurality of steps or a plurality of stages. The plurality of steps or stages are not necessarily executed at the same time, but may be executed at different times. The plurality of steps or stages are not necessarily executed sequentially, but may be executed in turn or alternately with other steps or at least some of steps or stages in the other steps.

In an embodiment, a chip short-circuit check apparatus is further provided. The apparatus is configured to implement the aforementioned embodiments and alternative implementations. Details that have been previously explained will not be repeated. Terms such as "module", "unit", "sub-unit" used below may refer to combinations of software and/or hardware capable of achieving predetermined functions. Although the apparatus described in the following embodiments is implemented in software, implementation via hardware, or a combination of software and hardware is also possible and envisaged.

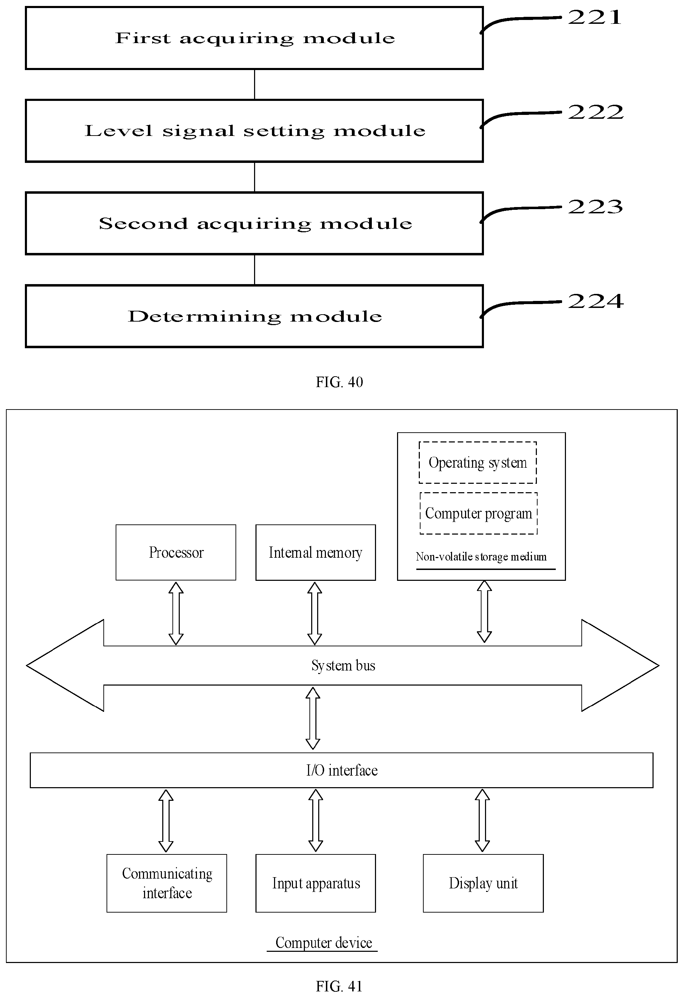

FIG. 40 is a structural block diagram of a chip short-circuit check apparatus according to an embodiment of the present invention. Referring to FIG. 40, the apparatus includes a first obtaining module 221, a level signal setting module 222, a second acquisition module 223, and a determining module 224.

The first obtaining module 221 is configured for acquiring a short-circuit check signal.

The level signal setting module 222 is configured for setting desired level signals for a data terminal in a to-be-tested chip at specified time points in a check response period based on the short-circuit check signal.

The second acquisition module 223 is configured for acquiring actual output level signals of the data terminal after the desired level signals are set for the data terminal.

The determining module 224 is configured for determining a short-circuit check result of the to-be-tested chip based on the actual output level signals. The short-circuit check result indicates that the to-be-tested chip functions normally although a short circuit between a reset terminal and at least one terminal other than the reset terminal exists in the to-be-tested chip, the to-be-tested chip functions normally and is free of short circuits, or the to-be-tested chip is functionally damaged.

In some embodiments, when the actual output level signals are inconsistent with the desired level signals, the short-circuit check result may indicate that the to-be-tested chip is functionally damaged.

In some embodiments, when the actual output level signals are consistent with the desired level signals, is may be determined that the to-be-tested chip functions normally, and the determining module 224 is further configured for determining whether a voltage of the reset terminal of the to-be-tested chip is continuously within a preset voltage range in the check response period, determining that no short circuit exists in the to-be-tested chip when the voltage of the reset terminal of the to-be-tested chip is continuously within the preset voltage range in the check response period, and determining that a short circuit between the reset terminal and at least one terminal other than the reset terminal exists in the to-be-tested chip when the voltage of the reset terminal of the to-be-tested chip is not continuously within the preset voltage range in the check response period.

In some embodiments, when the actual output level signals are consistent with the desired level signals, it may be determined that the to-be-tested chip functions normally, and the determining module 224 is further configured for determining whether the to-be-tested chip responds to a communicating command in a preset communicating period, determining that the short-circuit check result indicates that the to-be-tested chip functions normally although a short circuit between the reset terminal and at least one terminal other than the reset terminal exists in the to-be-tested chip when the to-be-tested chip does not respond to the communicating command in the preset communicating period, and determining that the short-circuit check result indicates that the to-be-tested chip functions normally and is free of short circuits when the to-be-tested chip responds to the communicating command in the preset communicating period. The communicating command may be transmitted by a printing device communicating with the to-be-tested chip, and the preset communicating period may be after the check response period.

In some embodiments, the level signal setting module 222 is specifically configured for determining a plurality of clock time points of a clock terminal in the to-be-tested chip based on the short-circuit check signal, determining the check response period based on the plurality of clock time points, determining the specified time points corresponding to the data terminal in the to-be-tested chip in the check response period, and setting the desired level signals at the specified time points corresponding to the data terminal.

In some embodiments, the specified time points may include a first specified time point, a second specified time point, and a third specified time point. The first specified time point may be earlier than the second specified time point, and the second specified time point may be earlier than the third specified time point. The level signal setting module 222 is specifically configured for setting a low-level signal at the first specified time point corresponding to the data terminal, setting a high-level signal at the second specified time point corresponding to the data terminal, and setting a low-level signal at the third specified time point corresponding to the data terminal.

In some embodiments, the first acquiring module 221 is specifically configured for acquiring original waveform data transmitted by a printing device, and determining the original waveform data as the short-circuit check signal when the original waveform data has a short-circuit check identifier.

It should be noted that the aforementioned modules may be functional modules or program modules, which may be implemented by software or hardware. For modules implemented by hardware, the aforementioned modules may be located in a same processor. Alternatively, the modules may be distributed across different processors in any combination.

In an embodiment, a chip is further provided. The chip includes a clock terminal, a data terminal, a power terminal, a grounding terminal, a reset terminal, and a processor. The processor is configured to perform the chip short-circuit check method according to any one of the aforementioned embodiments or perform the chip testing method according to any one of the aforementioned embodiments.

In an embodiment, a consumable box is further provided. The consumable box includes the chip in the aforementioned embodiments, to perform the chip short-circuit check method or the chip testing method described in any one of the aforementioned embodiments.

Specifically, the consumable box may include at least one of common consumable boxes such as an ink cartridge, a toner cartridge, or an ink bag box.

FIG. 16 is a schematic structural diagram of a consumable box according to an embodiment of the present invention. Referring to FIG. 16, a consumable box 300 is provided in the present invention. The consumable box 300 may include a box body 310 and a chip 100. The box body 310 may have a bottom wall 301 and side walls including a first side wall 302. The chip 100 may be mounted on the first sidewall 302.

The consumable box 300 may be mounted to, for example, a printer. In actual use, the Y-axis direction may be substantially a vertical direction. The bottom wall 301 may be downward, the first side wall 302 may be engaged with the printer, and the chip 100 may be electrically connected to the printer. Exemplarily, the consumable box 300 may include an ink outlet 303, which may be disposed on the bottom wall 301. Each of the side walls may be deflectable relative to the bottom wall 301, e.g., perpendicular to each other.

In an embodiment, a computer device is provided and may have an internal structure diagram referring to FIG. 41. FIG. 41 is a schematic diagram of an internal structure of a computer device according to an embodiment of the present disclosure. The computer device includes a processor, a memory, a communicating interface, a display screen and an input apparatus which are connected through a system bus. The processor of the computer device is configured to provide computing and control capabilities. The memory of the computer device includes a non-volatile storage medium and an internal memory. The non-volatile storage medium stores an operating system and a computer program. The internal memory provides an environment for running the operating system and the computer program in the non-volatile storage medium. The communicating interface of the computer device is configured to communicate with an external terminal device in a wired or wireless manner, and the wireless manner may be implemented by WIFI, a mobile cellular network, NFC (near field communication), or other technologies. The computer program, when executed by the processor, implements the aforementioned chip testing method or the chip short-circuit check method. The display screen of the computer device may be a liquid crystal display (LCD) screen or an electronic ink (e-ink) display screen. The input apparatus of the computer device may be a touch layer covering the display screen, or may be a button, a trackball, or a touch panel disposed on a housing of the computer device, or may be an external keyboard, touch panel, mouse, or the like.

One skilled in the art may understand that the structure shown in FIG. 41 is a block diagram of a partial structure related to the solution of the present disclosure, and does not limit the computer device to which the solution of the present disclosure is applied. Specifically, the computer device may include more or fewer components than those shown in the figure, or some components may be combined, or different component deployment may be used.

In an embodiment, a computer-readable storage medium is provided, storing a computer program. The computer program, when executed by a processor, implements steps in the aforementioned method embodiments.

One skilled in the art may understand that all or some of the procedures of the method in the foregoing embodiments may be implemented by a computer program instructing relevant hardware. The computer program may be stored in a non-volatile computer-readable storage medium. When the computer program is executed, the procedures of the foregoing method embodiments may be implemented. Any reference to a memory, a database, or another medium used in the embodiments provided in the present disclosure may include at least one of a non-volatile memory or a volatile memory. The non-volatile memory may include a read-only memory (ROM), a magnetic tape, a floppy disk, a flash memory, an optical memory, a high-density embedded non-volatile memory, a resistive random access memory (ReRAM), a magneto resistive random access memory (MRAM), a ferroelectric random access memory (FRAM), a phase change memory (PCM), a graphene memory, or the like. The volatile memory may include a random access memory (RAM), an external cache memory, or the like. As an illustration instead of a limitation, the RAM is available in various forms, such as a static random access memory (SRAM) or a dynamic random access memory (DRAM). The database involved in the embodiments provided in the present disclosure may include at least one of a relational database and a non-relational database. The non-relational database may include a blockchain-based distributed database and the like, but is not limited thereto. The processor involved in the embodiments provided in the present disclosure may be a general-purpose processor, a central processing unit, a graphics processor, a digital signal processor, a programmable logic device, a data processing logic device based on quantum computing, and the like, and is not limited thereto.

The technical features in the above embodiments may be randomly combined. For concise description, not all possible combinations of the technical features in the embodiments are described. However, all the combinations of the technical features are to be considered as falling within the scope described in this description provided that they do not conflict with each other.

The above embodiments only illustrate several implementations of the present invention, and the description thereof is specific and detailed, but cannot therefore be understood as limiting the protection scope of the present invention. It should be noted that those of ordinary skill in the art may further make variations and improvements without departing from the conception of the present invention, and these all fall within the protection scope of the present invention. Therefore, the protection scope of the present invention should be subject to the appended claims.

## Claims

1. A chip, adapted to be communicatively connected to a printer, comprising a substrate, a grounding terminal, at least two conductive terminals, and a testing portion, **characterized in that**
the substrate has a first half region and a second half region;
the grounding terminal comprises a ground wire contact portion configured to be in contact with a stylus of the printer, and the ground wire contact portion is located in the first half region of the substrate;
the at least two conductive terminals are located in the second half region of the substrate and arranged spaced apart from each other, each of the at least two conductive terminals comprises a contact portion configured to be in contact with a stylus of the printer, the at least two conductive terminals comprise a first conductive terminal and a second conductive terminal, and a distance between the contact portion of the first conductive terminal and the contact portion of the second conductive terminal is less than that between the ground wire contact portion and either of the contact portion of the first conductive terminal and the contact portion of the second conductive terminal; and
the testing portion is located on the substrate and electrically connected to the grounding terminal, the testing portion comprises a first testing line segment located between the first conductive terminal and the second conductive terminal, and the first testing line segment is arranged spaced apart from each of the first conductive terminal and the second conductive terminal.

2. The chip of claim 1, wherein the testing portion further comprises a second testing line segment, the second testing line segment and the first testing line segment are located at two adjacent sides of the first conductive terminal, and the second testing line segment cooperates with the first testing line segment to surround the first conductive terminal.

3. The chip of claim 2, wherein an intersecting point of the second testing line segment and the first testing line segment is proximal to the contact portion of the first conductive terminal and away from the ground wire contact portion.

4. The chip of claim 2, wherein the at least two conductive terminals further comprise a third conductive terminal, the third conductive terminal is spaced apart from the first conductive terminal, and the second testing line segment is located between the first conductive terminal and the third conductive terminal; and
the first conductive terminal is covered by a projection of the second testing line segment along an arraying direction of the third conductive terminal and the first conductive terminal.

5. The chip of claim 2 or claim 3, wherein the at least two conductive terminals further comprise a third conductive terminal and a fourth conductive terminal, and a distance between the contact portion of the third conductive terminal and the contact portion of the fourth conductive terminal is less than that between the ground wire contact portion and either of the contact portion of the third conductive terminal and the contact portion of the fourth conductive terminal;
the first conductive terminal and the second conductive terminal are arranged along a first direction, the fourth conductive terminal and the second conductive terminal are sequentially arranged along a second direction intersecting with the first direction, and the grounding terminal, the third conductive terminal and the first conductive terminal are sequentially arranged along the second direction; and
the contact portion of the first conductive terminal and the ground wire contact portion are symmetric with respect to a boundary dividing the first half region and the second half region.

6. The chip of claim 5, wherein the testing portion further comprises either or both of a third testing line segment and a fourth testing line segment,
the third testing line segment, the first testing line segment, and the second testing line segment cooperate with each other to surround the third conductive terminal; and
the fourth testing line segment is located between the second conductive terminal and the fourth conductive terminal, and the second conductive terminal is covered by a projection of the fourth testing line segment along an arraying direction of the fourth conductive terminal and the second conductive terminal.

7. The chip of any one of claims 1 to 3, wherein the at least two conductive terminals further comprise a third conductive terminal and a fourth conductive terminal, the contact portion of the first conductive terminal and the ground wire contact portion are asymmetric with respect to a boundary dividing the first half region and the second half region, and a connecting direction of the contact portion of the third conductive terminal and the ground wire contact portion is intersected with that of the contact portion of the second conductive terminal and the contact portion of the fourth conductive terminal.

8. The chip of any one of claims 1 to 3, wherein the at least two conductive terminals further comprise a third conductive terminal and a fourth conductive terminal, the first conductive terminal comprises a clock terminal, the second conductive terminal comprises a data terminal, the third conductive terminal comprises a power terminal, and the fourth conductive terminal comprises a reset terminal.

9. A consumable box, **characterized by** comprising the chip of any one of claims 1 to 8.

10. The consumable box of claim 9, comprising a box body, wherein the box body has a bottom wall and a side wall, the chip is mounted on the side wall of the box body, and a boundary of the chip configured for dividing the first half region and the second half region is perpendicular to the bottom wall; and
the grounding terminal and the second conductive terminal are disposed oppositely and separated by the first testing line segment, the grounding terminal is located at a side of the first testing line segment proximal to the bottom wall, the second conductive terminal is located at a side of the first testing line segment away from the bottom wall, and an extending direction of the first testing line segment is parallel to the bottom wall.

11. A chip testing method, applied to a to-be-tested chip provided with a testing portion, **characterized in that** the to-be-tested chip further comprises a substrate, a grounding terminal, a clock terminal, a data terminal, a power terminal, and a reset terminal; the testing portion is located on the substrate and electrically connected to the grounding terminal, the testing portion comprises a first testing line segment, a second testing line segment, and a grounding line segment, the first testing line segment is connected to the grounding terminal through the grounding line segment, the data terminal and the reset terminal are located at a side of the first testing line segment, the clock terminal and the power terminal are located at another side of the first testing line segment, the second testing line segment is connected to the first testing line segment, and the clock terminal and the power terminal are separated by the second testing line segment, and the method comprises:
acquiring a short-circuit check signal;
setting desired level signals for the data terminal in the to-be-tested chip at specified time points in a check response period based on the short-circuit check signal;
acquiring actual output level signals of the data terminal after the desired level signals are set for the data terminal; and
determining a test result of the to-be-tested chip based on the actual output level signals, wherein the test result of the to-be-tested chip indicates that the to-be-tested chip functions normally or the to-be-tested chip has faults.

12. The chip testing method of claim 11, wherein determining the test result of the to-be-tested chip based on the actual output level signals further comprises:
when the actual output level signals are consistent with the desired level signals, determining that the test result of the to-be-tested chip indicates that the to-be-tested chip functions normally; and
when the actual output level signals are inconsistent with the desired level signals, determining that the test result of the to-be-tested chip indicates that the to-be-tested chip has the faults, wherein the faults of the to-be-tested chip comprise at least one of a short circuit between remaining terminals of the to-be-tested chip other than the reset terminal, either or both of a short circuit between the reset terminal and the clock terminal and a short circuit between the reset terminal and the power terminal, a short circuit between any terminal other than the reset terminal and the testing portion, or a functional damage of the to-be-tested chip.

13. The chip testing method of claim 12, wherein when the actual output level signals are consistent with the desired level signals, the method further comprises:
determining whether a voltage of the reset terminal of the to-be-tested chip is continuously within a preset voltage range in the check response period;
when the voltage of the reset terminal of the to-be-tested chip is continuously within the preset voltage range in the check response period, determining that no short circuit exists in the to-be-tested chip; and
when the voltage of the reset terminal of the to-be-tested chip is not continuously within the preset voltage range in the check response period, determining that a short circuit between the reset terminal and the data terminal or a short circuit between the reset terminal and the grounding terminal exists in the to-be-tested chip.

14. A chip short-circuit check method, **characterized by** comprising:
acquiring a short-circuit check signal;
setting desired level signals for a data terminal in a to-be-tested chip at specified time points in a check response period based on the short-circuit check signal;
acquiring actual output level signals of the data terminal after the desired level signals are set for the data terminal; and
determining a short-circuit check result of the to-be-tested chip based on the actual output level signals, wherein the short-circuit check result indicates that the to-be-tested chip functions normally although a short circuit between a reset terminal and at least one terminal other than the reset terminal exists in the to-be-tested chip, the to-be-tested chip functions normally and is free of short circuits, or the to-be-tested chip is functionally damaged.

15. The chip short-circuit check method of claim 14, wherein determining the short-circuit check result of the to-be-tested chip based on the actual output level signals further comprises:
when the actual output level signals are inconsistent with the desired level signals, determining that the short-circuit check result indicates that the to-be-tested chip is functionally damaged.

16. The chip short-circuit check method of claim 15, wherein when the actual output level signals are consistent with the desired level signals, it is determined that the to-be-tested chip functions normally, and the method further comprises:
determining whether a voltage of the reset terminal of the to-be-tested chip is continuously within a preset voltage range in the check response period;
when the voltage of the reset terminal of the to-be-tested chip is continuously within the preset voltage range in the check response period, determining that no short circuit exists in the to-be-tested chip; and
when the voltage of the reset terminal of the to-be-tested chip is not continuously within the preset voltage range in the check response period, determining that a short circuit between the reset terminal and at least one terminal other than the reset terminal exists in the to-be-tested chip.

17. The chip short-circuit check method of claim 15, wherein when the actual output level signals are consistent with the desired level signals, it is determined that the to-be-tested chip functions normally, and the method further comprises:
determining whether the to-be-tested chip responds to a communicating command in a preset communicating period, wherein the communicating command is transmitted by a printing device communicating with the to-be-tested chip, and the preset communicating period is after the check response period;
when the to-be-tested chip does not respond to the communicating command in the preset communicating period, determining that the short-circuit check result indicates that the to-be-tested chip functions normally although a short circuit between the reset terminal and at least one terminal other than the reset terminal exists in the to-be-tested chip; and
when the to-be-tested chip responds to the communicating command in the preset communicating period, determining that the short-circuit check result indicates that the to-be-tested chip functions normally and is free of short circuits.

18. The chip short-circuit check method of claim 14, wherein setting the desired level signals for the data terminal in the to-be-tested chip at the specified time points in the check response period based on the short-circuit check signal further comprises:
determining a plurality of clock time points of a clock terminal in the to-be-tested chip based on the short-circuit check signal;
determining the check response period based on the plurality of clock time points;
determining the specified time points corresponding to the data terminal in the to-be-tested chip in the check response period; and
setting the desired level signals at the specified time points corresponding to the data terminal.

19. The chip short-circuit check method of claim 18, wherein the specified time points comprise a first specified time point, a second specified time point, and a third specified time point, the first specified time point is earlier than the second specified time point, the second specified time point is earlier than the third specified time point, and setting the desired level signals at the specified time points corresponding to the data terminal further comprises:
setting a low-level signal at the first specified time point corresponding to the data terminal, setting a high-level signal at the second specified time point corresponding to the data terminal, and setting a low-level signal at the third specified time point corresponding to the data terminal.

20. The chip short-circuit check method of claim 14, wherein acquiring the short-circuit check signal further comprises:
acquiring original waveform data transmitted by a printing device; and
determining the original waveform data as the short-circuit check signal when the original waveform data has a short-circuit check identifier.

21. A chip short-circuit check apparatus, **characterized by** comprising a first acquiring module, a level signal setting module, a second acquiring module, and a determining module,
wherein the first acquiring module is configured for acquiring a short-circuit check signal; the level signal setting module is configured for setting desired level signals for a data terminal in a to-be-tested chip at specified time points in a check response period based on the short-circuit check signal;
the second acquiring module is configured for acquiring actual output level signals of the data terminal after the desired level signals are set for the data terminal; and
the determining module is configured for determining a short-circuit check result of the to-be-tested chip based on the actual output level signals, wherein the short-circuit check result indicates that the to-be-tested chip functions normally although a short circuit between a reset terminal and at least one terminal other than the reset terminal exists in the to-be-tested chip, the to-be-tested chip functions normally and is free of short circuits, or the to-be-tested chip is functionally damaged.

22. A chip, comprising a clock terminal, a data terminal, a power terminal, a grounding terminal, a reset terminal, and a processor, **characterized in that** the processor is configured to perform the chip testing method of any one of claims 11 to 13, or perform the chip short-circuit check method of any one of claims 14 to 20.

23. A consumable box, **characterized by** comprising the chip of claim 22.
